(19) Europäisches Patentamt
European Patent Office
Office européen des brevets

(11) EP 3 025 791 A1

(12) EUROPEAN PATENT APPLICATION
published in accordance with Art. 153(4) EPC

(43) Date of publication:
01.06.2016 Bulletin 2016/22

(51) Int Cl.:
B05D 5/06 (2006.01)   B29C 59/02 (2006.01)
B32B 3/30 (2006.01)   B32B 9/00 (2006.01)
G02B 5/18 (2006.01)   H01L 51/50 (2006.01)
H05B 33/02 (2006.01)  H05B 33/10 (2006.01)

(21) Application number: 14829701.3

(22) Date of filing: 26.05.2014

(86) International application number:
PCT/JP2014/063802

(87) International publication number:
WO 2015/011980 (29.01.2015 Gazette 2015/04)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 26.07.2013 JP 2013156073

(71) Applicant: JX Nippon Oil & Energy Corporation
Chiyoda-ku
Tokyo 100-8162 (JP)

(72) Inventors:
• MASUYAMA, Satoshi
  Tokyo 100-8162 (JP)
• SHIBANUMA, Toshihiko
  Tokyo 100-8162 (JP)
• TORIYAMA, Shigetaka
  Tokyo 100-8162 (JP)
• NISHIMURA, Suzushi
  Tokyo 100-8162 (JP)

(74) Representative: Kuhnen & Wacker
Patent- und Rechtsanwaltsbüro
Prinz-Ludwig-Straße 40A
85354 Freising (DE)

(54) METHOD FOR MANUFACTURING SUBSTRATE HAVING TEXTURED STRUCTURE

(57) A method for manufacturing a substrate with a concave-convex structure includes: forming a base material layer 12 on a substrate 10; forming a base layer 13 having a concave-convex pattern by transferring a concave-convex pattern of a mold to the base material layer 12; and forming a coating layer 14 by coating the concave-convex pattern of the base layer 13 with a coating material, wherein the coating layer 14 is formed such that a thickness of the coating layer 14 is in a range of 25 to 150% of standard deviation of depth of concavities and convexities of the base layer 13. The substrate with the concave-convex structure manufactured by this method has good light extraction efficiency and effectively prevents leak current in an organic light emitting diode having this substrate.

Fig. 1

(a)

(b)

(c)

## Description

## Technical Field

The present invention relates to a method for manufacturing a substrate having a concave-convex structure (textured structure, concave and convex structure) with an imprint method.

## Background Art

The nanoimprint method is known, in addition to the lithography method, as a method for forming a fine pattern (minute pattern) such as a semiconductor integrated circuit. The nanoimprint method is a technology capable of transferring a pattern in nanometer order by sandwiching a resin between a mold (die) and a substrate. A thermal nanoimprint method, a photonanoimprint method, and the like have been used depending on the employed material. Of the above methods, the photonanoimprint method includes four steps of: i) resin coating; ii) pressing with the mold; iii) photo-curing; and iv) mold-releasing. The photonanoimprint method is excellent in that processing on a nanoscale can be achieved by the simple process as described above. Especially, since a photo-curable resin curable by being irradiated with light is used for the resin layer, a period of time for a pattern transfer step is short and high throughput is promised. Thus, the photonanoimprint method is expected to be practiced not only in the field of semiconductor device but also in many fields such as optical members like organic EL (electro-luminescence) element, LED, etc.; MEMS; biochips; and the like.

In the organic EL element (organic light emitting diode), a hole injected from an anode through a hole injecting layer and electron injected from a cathode through an electron injecting layer are carried to a light emitting layer respectively, then the hole and electron are recombined on an organic molecule in the light emitting layer to excite the organic molecule, thereby generating light emission. Therefore, when the organic EL element is used as a display device and/or an illumination device, the light from the light emitting layer is required to be efficiently extracted from the surface of the organic EL element. In order to meet this demand, PATENT LITERATURE 1 discloses that a diffraction grating substrate having a concave-convex structure is provided on a light extraction surface of the organic EL element.

## Citation List

## Patent Literature

PATENT LITERATURE 1: Japanese Patent Application Laid-open No. 2006-236748
PATENT LITERATURE 2: International Publication No. WO2011/007878 A1

The present applicant has disclosed the following method in PATENT LITERATURE 2. That is, in order to manufacture a concave-convex pattern of the diffraction grating substrate for the organic EL element, a base member is coated with a solution which is obtained by dissolving, in a solvent, a block copolymer that fulfills a predetermined condition, and a micro phase separation structure of the block copolymer is formed by using a self-organizing phenomenon of the block copolymer, thereby obtaining a master block (mold, metal substrate) in which a fine (minute) and irregular concave-convex pattern is formed. A mixture of a silicone-based polymer and a curing agent is dropped onto the obtained master block and then cured to obtain a transferred pattern as a mold. Then, a glass substrate coated with a curable resin is pressed to (against) the transferred pattern, and the curable resin is cured by irradiation with ultraviolet light. In this way, a diffraction grating in which the transferred pattern is duplicated is manufactured. The organic EL element is obtained by stacking a transparent electrode, an organic layer, and a metal electrode on the diffraction grating.

## Summary of Invention

## Technical Problem

However, the investigation and study of the present applicant have revealed that manufacturing the substrate with the concave-convex structure by such a nanoimprint method described in each of the patent literatures may cause a defect on the concave-convex pattern surface of the substrate. For example, when a mold surface has any damage and/or foreign substances, it/they may be transferred to the resin on the substrate and the foreign substances may adhere to the resin on the substrate. These situations may cause any pattern defect. Further, when the mold is released from the resin, a part of the resin may be peeled off from the substrate to cause the pattern defect. The investigation and study of the present applicant have revealed that the organic EL element, in which the substrate having the concave-convex structure manufactured by the nanoimprint method is used as a substrate for light extraction, is easy to cause the leak current due to the pattern defect and that light emission efficiency (current efficiency) thereof is insufficient, although it is required to develop an organic EL element having small leak current and sufficient light emission efficiency in order to put the organic light-emitting element into practical use in many fields such as displays and illumination devices (lighting devices).

In view of the above, an object of the present invention is to provide a method for manufacturing a substrate with a concave-convex structure which has less defects on its surface. Further, the present invention provides an organic EL element (organic Electro-Luminescence element or organic light emitting diode) having small leak current and high light emission efficiency.

**Solution to the Problem**

According to a first aspect of the present invention, there is provided a method for manufacturing a substrate with a concave-convex structure, including: forming a base material layer on a substrate; forming a base layer having a concave-convex pattern by transferring a concave-convex pattern of a mold to the base material layer; and forming a coating layer by coating the concave-convex pattern of the base layer with a coating material, wherein the coating layer is formed such that a thickness of the coating layer is in a range of 25 to 150% of standard deviation of depth of concavities and convexities of the base layer.

In the method for manufacturing the substrate with the concave-convex structure, a maintenance ratio of standard deviation of depth of concavities and convexities of the coating layer to the standard deviation of the depth of the concavities and convexities of the base layer may be in a range of 50 to 95%.

In the method for manufacturing the substrate with the concave-convex structure, the coating material may be a sol-gel material. The coating material may be a silane coupling agent. The coating material may be a resin. The coating material may contain an ultraviolet absorbent material.

In the method for manufacturing the substrate with the concave-convex structure, the base material layer may be made of a sol-gel material.

In the method for manufacturing the substrate with the concave-convex structure, the base material layer may be made of a same material as the coating material. When the base material layer is formed on the substrate by coating the substrate with a base material, the base material and the coating material may be in a form of solution containing the same material respectively. A concentration of the same material in the solution of the coating material may be lower than a concentration of the same material in the solution of the base material.

In the method for manufacturing the substrate with the concave-convex structure, the thickness of the coating layer may be in a range of 25 to 100% of the standard deviation of the depth of the concavities and convexities of the base layer.

In the method for manufacturing the substrate with the concave-convex structure, a maintenance ratio of standard deviation of depth of concavities and convexities of the coating layer to the standard deviation of the depth of the concavities and convexities of the base layer may be in a range of 70 to 95%.

In the method for manufacturing the substrate with the concave-convex structure, the coating layer may include an irregular concave-convex pattern, in which orientations of concavities and convexities have no directionality, on a surface on a side opposite to the substrate.

In the method for manufacturing the substrate with the concave-convex structure, the coating layer may include a concave-convex pattern in which an average pitch of concavities and convexities is in a range of 100 to 1500 nm and standard deviation of depth of the concavities and convexities is in a range of 10 to 100 nm.

According to a second aspect of the present invention, there is provided a substrate with a concave-convex structure obtained by the method for manufacturing the substrate with concave-convex structure as defined in the first aspect.

In the substrate with the concave-convex structure, the substrate with the concave-convex structure may be a substrate used for manufacturing an organic light emitting diode.

According to a third aspect of the present invention, there is provided an organic light emitting diode, including the substrate with the concave-convex structure as defined in the second aspect as a diffraction grating substrate with a concave-convex surface, wherein the organic light emitting diode is formed by successively stacking a first electrode, an organic layer, and a metal electrode on the concave-convex surface of the diffraction grating substrate.

The organic light emitting diode may further include an optical functional layer on a surface on a side opposite to the concave-convex surface of the diffraction grating substrate.

**Advantageous Effects of Invention**

In the method for manufacturing the substrate with the concave-convex structure according to the present invention, the substrate with the concave-convex structure is manufactured such that the coating layer is formed on the concave-convex pattern of the base layer formed by the transfer method, the coating layer having a thickness in a range of 25 to 150% of the standard deviation of depth of concavities and convexities of the base layer. Owing to this, the substrate with the concave-convex structure has no foreign substance and no defect on the surface of the concave-convex structure. When this substrate is used as a substrate for the organic light emitting diode, the substrate can have good light extraction efficiency while effectively preventing leak current of the organic light emitting diode. Thus, the method for manufacturing the substrate with the concave-convex structure according to the present invention is very effective for manufacturing the substrate used for various devices such as organic light emitting diode.

**Brief Description of Drawings**

Figs. 1(a) to 1(c) conceptually depict steps in a method for manufacturing a substrate with a concave-convex structure according to an embodiment.

Fig. 2 conceptually depicts an exemplary transfer step in the manufacturing method according to the embodiment.

Fig. 3 is a schematic sectional view depicting a cross-section structure of an exemplary organic EL element according to the embodiment.

Fig. 4 is a schematic sectional view depicting a cross-section structure of another exemplary organic EL element according to the embodiment.

Fig. 5 is a schematic sectional view depicting a cross-section structure of an organic EL element including an optical functional layer according to a modified embodiment.

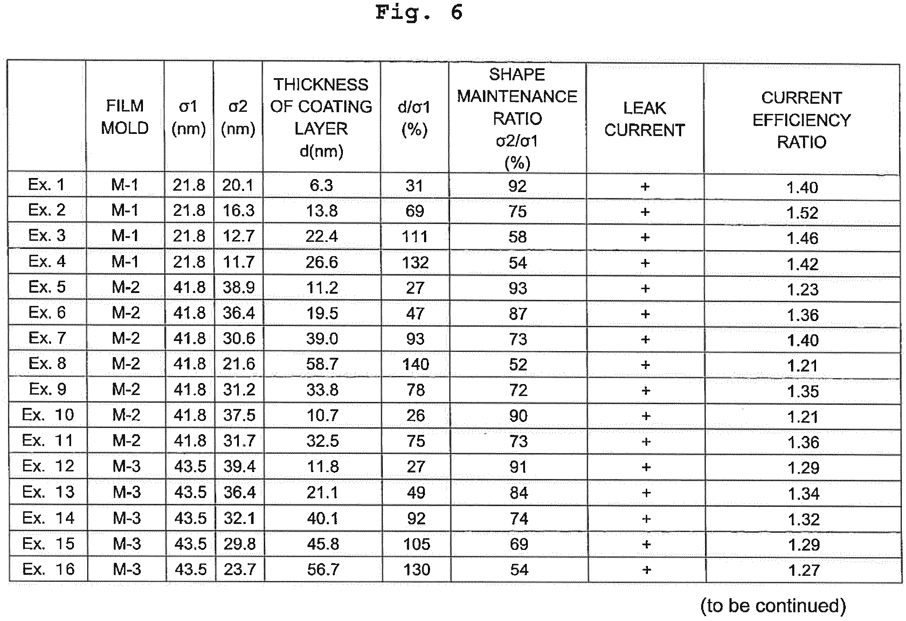

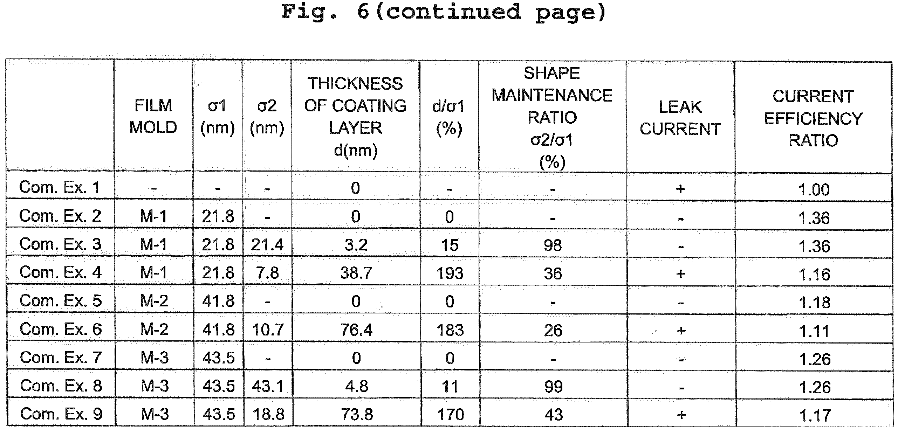

Fig. 6 is a table showing the standard deviation of depth of concavities and convexities in a surface of a base layer, the standard deviation of depth of concavities and convexities in a surface of a coating layer, the thickness of the coating layer, the ratio of the thickness of the coating layer to the standard deviation of depth of concavities and convexities in the surface of the base layer, the shape maintenance ratio, the result of the leak current evaluation, and the result of the current efficiency evaluation, of an organic EL element obtained in each of Examples and Comparative Examples (indicated as "Ex." and "Com. Ex." in Fig. 6).

Fig. 7 is a schematic sectional view depicting a cross-section structure of an organic EL element in Comparative Example 1.

Fig. 8 is a schematic sectional view depicting a cross-section structure of an organic EL element in each of Comparative Examples 2, 5, and 7.

Fig. 9 is a graph in which the shape maintenance ratio is plotted against the ratio of the thickness of the coating layer to the standard deviation of depth of concavities and convexities in the surface of the base layer in an organic EL element in each of Examples.

Fig. 10(a) is an exemplary AFM image of a concave-convex pattern, which is obtained by transferring a concave-convex pattern of a film-shaped mold used in the method for manufacturing the substrate with the concave-convex structure according to the embodiment; and Fig. 10(b) depicts a cross-section profile taken along the cutting-plane line in the AFM image of Fig. 10(a).

## Description of Embodiments

In the following, an explanation will be made with reference to the drawings about an embodiment of a method for manufacturing a substrate with a concave-convex structure, the substrate manufactured by the method, and an organic EL element manufactured by using the substrate according to the present invention.

The method for manufacturing the substrate with the concave-convex structure according to this embodiment mainly includes: forming a base material layer (foundation material layer) on a substrate; forming a base layer (foundation layer) having a concave-convex pattern; and forming a coating layer. These steps will be explained below in that order. Note that a case in which the base layer and the coating layer are made of sol-gel material(s) is used as an example in the following explanation.

[Formation of base material layer]

In order to form the base layer with the pattern transferred thereon using a sol-gel method, a solution of the sol-gel material (sol-gel material solution) to be used as the base material is prepared first. It is preferred that the base layer be made of an inorganic material, because the inorganic material is excellent in heat resistance. As the base material, it is possible to use, in particular, silica, a titanium-based material, a material based on indium tin oxide (ITO), or a sol-gel material such as ZnO, $ZrO_2$, or $Al_2O_3$. For example, when the base layer made of silica is formed on a substrate by the sol-gel method, a sol-gel material of metal alkoxide (silica precursor) is prepared as the base material. Those usable as the silica precursor include tetraalkoxide monomers represented by tetraalkoxysilane such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers represented by trialkoxysilane such as methyltrimethoxysilane, ethyltrimethoxysilane, propyltrimethoxysilane, isopropyltrimethoxysilane, phenyltrimethoxysilane, methyltriethoxysilane, ethyltriethoxysilane, propyltriethoxysilane, isopropyltriethoxysilane, phenyltriethoxysilane, methyltripropoxysilane, ethyltripropoxysilane, propyltripropoxysilane, isopropyltripropoxysilane, phenyltripropoxysilane, methyltriisopropoxysilane, ethyltriisopropoxysilane, propyltriisopropoxysilane, isopropyltriisopropoxysilane, phenyltriisopropoxysilane, and tolyltriethoxysilane; and dialkoxide monomers represented by dialkoxysilane such as dimethyldimethoxysilane, dimethyldiethoxysilane, dimethyldipropoxysilane, dimethyldiisopropoxysilane, dimethyldi-n-butoxysilane, dimethyldi-i-butoxysilane, dimethyldi-sec-butoxysilane, dimethyldi-t-butoxysilane, diethyldimethoxysilane, diethyldiethoxysilane, diethyldipropoxysilane, diethyldiisopropoxysilane, diethyldi-n-butoxysilane, diethyldi-i-butoxysilane, diethyldi-sec-butoxysilane, diethyldi-t-butoxysilane, dipropyldimethoxysilane, dipropyldiethoxysilane, dipropyldipropoxysilane, dipropyldiisopropoxysilane, dipropyldi-n-butoxysilane, dipropyldi-i-butoxysilane, dipropyldi-sec-butoxysilane, dipropyldi-t-butoxysilane, diisopropyldimethoxysilane, diisopropyldiethoxysilane, diisopropyldipropoxysilane, diisopropyldiisopropoxysilane, diisopropyldi-n-butoxysilane, diisopropyldi-i-butoxysilane, diisopropyldi-sec-butoxysilane, diisopropyldi-t-butoxysilane, diphenyldimethoxysilane, diphenyldiethoxysilane, diphenyldipropoxysilane, diphenyldiisopropoxysilane, diphenyldi-n-butoxysilane, diphenyldi-i-butoxysilane, diphenyldi-sec-butoxysilane, and diphenyldi-t-butoxysilane. Further, it is possible to use alkyltrialkoxysilane or dialkyldialkoxysilane which has alkyl group having C4 to C18 carbon atoms. It is possible to use metal alkoxides including, for example, monomers having vinyl group such as vinyltrimethoxysilane and vinyltriethoxysilane; monomers having epoxy group such as 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane; monomers having styryl group such as p-styryltrimethoxysilane; monomers having methacrylic group such as 3-methacryloxypropylmethyldimethoxysilane, 3-methacryloxypropyltrimethoxysilane, 3-methacryloxypropylmethyldiethoxysilane, and 3-methacryloxypropyltriethoxysilane; monomers having acrylic group such as 3-acryloxypropyltrimethoxysilane; monomers having amino group such as N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; monomer having ureide group such as 3-ureidepropyltriethoxysilane; monomers having mercapto group such as 3-mercaptopropylmethyldimethoxysilane and 3-mercaptopropyltrimethoxysilane; monomers having sulfide group such as bis(triethoxysilylpropyl) tetrasulfide; monomers having isocyanate group such as 3-isocyanatopropyltriethoxysilane; polymers obtained by polymerizing the foregoing monomers in small amounts; and composite materials characterized in that functional group and/or polymer is/are introduced into a part of the material as described above. Further, a part of or all of the alkyl group and the phenyl group in each of the above compounds may be substituted with fluorine. Further, examples of the silica precursor include metal acetylacetonate, metal carboxylate, oxychloride, chloride, and mixtures thereof. The silica precursor, however, is not limited thereto. In addition to Si, examples of the metal species include Ti, Sn, Al, Zn, Zr, In, and mixtures thereof, but are not limited thereto. It is also possible to use any appropriate mixture of precursors of the oxides of the above metals. Further, it is possible to use, as the silica precursor, a silane coupling agent having, in its molecule, a hydrolysis group having the affinity and the reactivity with silica and an organic functional group having the water-repellence. For example, there are exemplified silane monomer such as n-octyltriethoxysilane, methyltriethoxysilane, and methyltrimethoxysilane; vinylsilane such as vinyltriethoxysilane, vinyltrimethoxysilane, vinyltris(2-methoxyethoxy)silane, and vinylmethyldimethoxysilane; methacrylsilane such as 3-methacryloxypropyltriethoxysilane and 3-methacryloxypropyltrimethoxysilane; epoxysilane such as 2-(3,4-epoxycyclohexyl)ethyltrimethoxysilane, 3-glycidoxypropyltrimethoxysilane, and 3-glycidoxypropyltriethoxysilane; mercaptosilane such as 3-mercaptopropyltrimethoxysilane and 3-mercaptopropyltriethoxysilane; sulfursilane such as 3-octanoylthio-1-propyltriethoxysilane; aminosilane such as 3-aminopropyltriethoxysilane, 3-aminopropyltrimethoxysilane, N-(2-aminoethyl)-3-aminopropyltrimethoxysilane, N-(2-aminoethyl)-3-aminopropylmethyldimethoxysilane, and 3-(N-phenyl)-aminopropyltrimethoxysilane; and polymers obtained by polymerizing the monomers as described above.

When a mixture of TEOS and MTES is used as the sol-gel material solution, the mixture ratio thereof can be, for example, 1:1 in a molar ratio. The sol-gel material produces amorphous silica by being subjected to hydrolysis and polycondensation reaction. An acid such as hydrochloric acid or an alkali such as ammonia is added in order to adjust the pH of the solution as a synthesis condition. A material, which generates an acid or alkali by irradiation with light such as ultraviolet rays, may be added. The pH is preferably not more than 4 or not less than 10. Water may be added to perform the hydrolysis. The amount of water to be added can be not less than 1.5 times, with respect to the amount of metal alkoxide species, in the molar ratio.

The solvent of the sol-gel material solution is exemplified, for example, by alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive of the sol-gel material solution, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, dioxane, and the like, as a solution stabilizer.

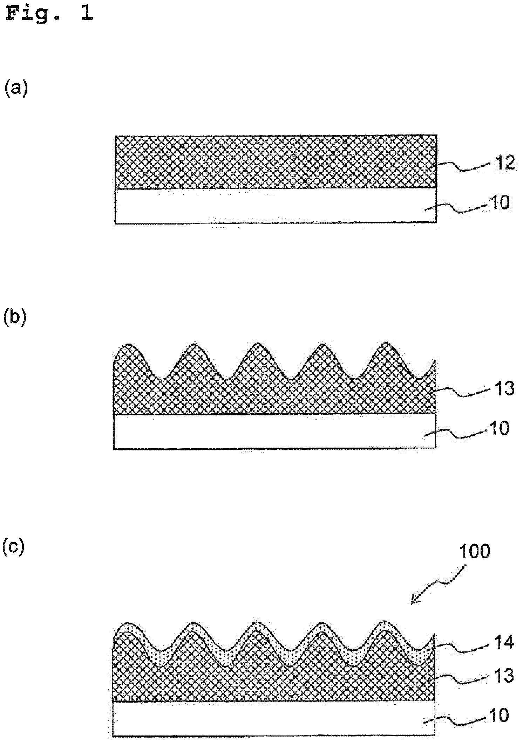

As depicted in Fig. 1(a), a substrate 10 is coated with the sol-gel material solution prepared as described above to form a base material layer 12. As the substrate 10, substrates made of inorganic materials such as glass, silica glass, and silicon substrates or substrates of resins such as polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate may be used. The substrate 10 may be transparent or opaque. If a substrate having the concave-convex pattern obtained by using this substrate is used for production of a display, the substrate 10 desirably has the heat resistance and the light resistance against, for example, ultraviolet (UV) light. In these respects, substrates made of inorganic materials such as glass, silica glass, and silicon substrates are more preferably used as the substrate 10. Especially, when the substrate 10 is made of an inorganic material, the base layer which will be described later may be made of an inorganic material such as a sol-gel material layer. In this case, the difference between the refractive index of the substrate 10 and the refractive index of the base layer is small and unintended refraction and/or reflection in the optical substrate can be prevented. Thus, the substrate 10 made of any inorganic material is preferred. It is allowable to perform a surface treatment or provide an easy-adhesion layer on the substrate 10 in order to improve an adhesion property, and to provide a gas barrier layer in order to keep out moisture and/or gas such as oxygen. Further, an optical functional layer, which has various optical functions such as light collection and light diffusion, may be formed on a surface, of the substrate 10, on the side opposite to the surface on which the base layer as described later is to be formed. As the coating method, it is possible to use any coating method including, for example, a bar coating method, a spin coating method, a spray coating method, a dip coating method, a die coating method, and an ink-jet method. The bar coating method, the die coating method, and the spin coating method are preferable, because the substrate having a relatively large area can be coated uniformly with the sol-gel material and the coating can be quickly completed prior to curing (gelation) of the sol-gel material. Note that, since the base layer, which is made of the sol-gel material and has a desired concave-convex pattern, is to be formed in subsequent steps, the surface of the substrate 10 (including the surface on which the surface treatment has been performed or the easy-adhesion layer if the surface treatment has been performed or the easy-adhesion layer has been formed) may be flat, and the substrate 10 itself does not have the desired concave-convex pattern. The thickness of the base material layer 12 may be, for example, in a range of 100 to 500 nm.

After the coating of the substrate 10 with the base material (sol-gel material), the substrate 10 may be kept (held) in the atmospheric air or under reduced pressure in order to evaporate the solvent contained in the base material layer 12 (coating film). When the holding time of the substrate 10 is short, the viscosity of the base material layer 12 is too low to transfer the concave-convex pattern to the base material layer 12 in the subsequent base layer formation step. When the holding time of the substrate 10 is too long, the polymerization reaction of the precursor proceeds and the viscosity of the base material layer 12 increases too much. This makes it impossible to transfer the concave-convex pattern to the base material layer 12 in the base layer formation step. After the coating of the substrate 10 with the sol-gel material, the polymerization reaction of the precursor proceeds as the evaporation of the solvent proceeds, and the physical property such as the viscosity of sol-gel material also changes in a short time. From the viewpoint of the stability of concave-convex pattern formation, it is preferred that drying time which enables a good pattern transfer have a sufficiently wide range. The range of the drying time which enables a good pattern transfer can be adjusted by the drying temperature (holding temperature), the drying pressure, the kind of sol-gel material, the ratio of mixed sol-gel materials, the solvent amount used at the time of preparation of the sol-gel material (concentration of sol-gel material), etc.

[Base layer formation step]

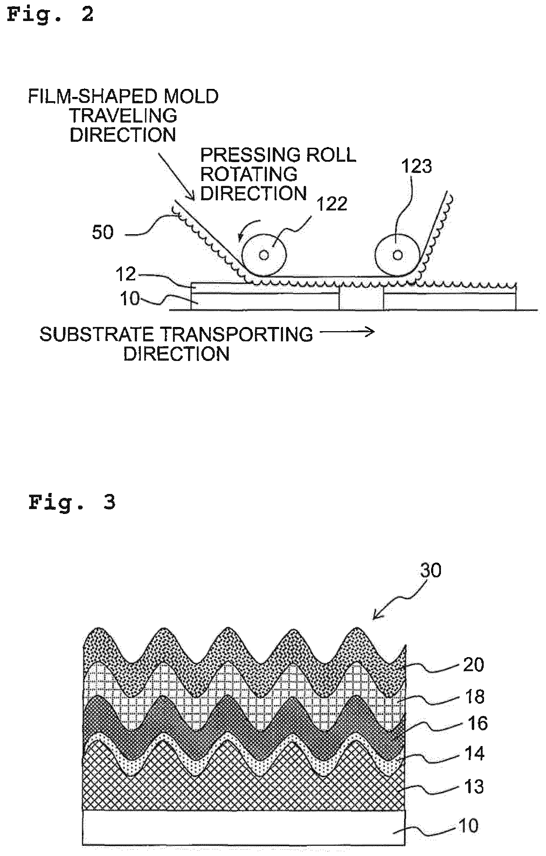

Next, a mold for concave-convex pattern transfer is used to transfer the concave-convex pattern of the mold to the base material layer, thereby forming a base layer 13 having a concave-convex pattern as depicted in Fig. 1(b). A film-shaped mold or metal mold can be used as the mold, and it is preferred that a flexible film-shaped mold be used as the mold. In this situation, a pressing roll may be used to press the mold against the base material layer. The roll process using the pressing roll has the following advantages over the pressing system. For example, the period of time during which the mold and the coating film are brought in contact with each other is short, and hence it is possible to prevent any deformation or collapse of pattern which would be otherwise caused by the difference in thermal expansion coefficient among the mold, the substrate, and a stage on which the substrate is placed, etc.; it is possible to prevent the generation of bubbles of gas in the pattern due to the bumping of the solvent in the sol-gel material solution or to prevent any trace or mark of gas from remaining; it is possible to reduce the transfer pressure and the releasing force (peeling force) owing to the line contact with the substrate (coating film), thereby making it possible to easily handle a substrate with larger area; and no bubble is included during the pressing. Further, the substrate may be heated while the mold is being pressed thereto. Fig. 2 depicts an example in which the mold is pressed against the base material layer by using the pressing roll. As depicted in Fig. 2, the concave-convex pattern of a film-shaped mold 50 can be transferred to the base material layer 12 on the substrate 10 by sending the film-shaped mold 50 between a pressing roll 122 and the substrate 10 being transported immediately below the pressing roll 122. That is, when the film-shaped mold 50 is pressed against the base material layer 12 with the pressing roll 122, the surface of the base material layer 12 on the substrate 10 is coated (covered) with the film-shaped mold 50 while the film-shaped mold 50 and the substrate 10 are synchronously transported. In this situation, by rotating the pressing roll 122 while pressing the pressing roll 122 against the back surface (surface on the side opposite to the surface in which the concave-convex pattern is formed) of the film-shaped mold 50, the film-shaped mold 50 moves with the substrate 10 to adhere to the substrate 10. In order to send the long film-shaped mold 50 to the pressing roll 122, it is advantageous that the film-shaped mold 50 is fed directly from a film roll around which the long film-shaped mold 50 is wound.

The film-shaped mold used in this embodiment may be a film-shaped or sheet-shaped mold having a concave-convex transfer pattern on a surface thereof. The mold is made, for example, of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The concave-convex pattern may be formed directly in (on) each of the materials, or may be formed in (on) a concave-convex forming material with which a base member (substrate sheet) formed of the above-mentioned materials is coated. It is possible to use a photosetting resin, a thermosetting resin, and a thermoplastic resin as the concave-convex forming material.

The size of the film-shape mold, in particular, the length thereof can be set appropriately based on the size of the optical substrate to be mass-produced and/or the number of optical substrates (the number of lots) continuously produced in a single manufacturing process. For example, the film-shaped mold may be a long mold having 10 meter or more in length, and the pattern transfer may be performed continuously on a plurality of substrates while the film-shaped mold wound around a roll is continuously fed from the roll. The film-shaped mold may be 50 to 3000 mm in width, and 1 to 500 $\mu$m in thickness. A surface treatment or an easy-adhesion treatment may be performed to improve an adhesion property between the substrate and the concave-convex forming material. Further, a mold-release treatment may be performed on each surface of the concave-convex pattern as needed. The concave-convex pattern may be formed to have any profile by any method. The concave-convex pattern of the film-shaped mold may be any pattern such as a microlens array structure or a structure having the light diffusion function, light diffraction function, etc.

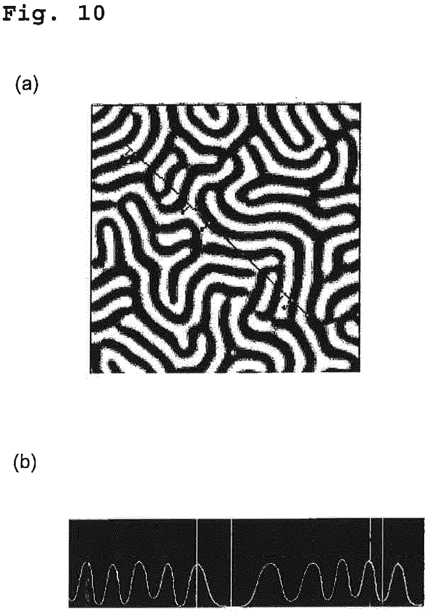

For example, the cross-sectional shape of the concave-convex pattern of the film-shaped mold may be formed of relatively gentle (smooth) inclined (sloped) surfaces, that is, the cross-sectional shape of the concave-convex pattern of the film-shaped mold may be a wave-like shape (referred to as "wave-like structure" as appropriate in the present application) in a direction upward from the base member. Namely, each convex portion of the concave-convex pattern may have a cross-sectional shape which narrows from the bottom on the base member side toward the top. The concave-convex pattern of the film-shaped mold may be characterized in that the concave portions and convex portions may have an elongated shape, as viewed in a plan view, in which concave portions and convex portions extend meanderingly or tortuously, and may have irregular extending directions, irregular waviness directions (bending directions), and irregular lengths in the extending directions thereof. In this case, the concave-convex pattern of the film-shaped mold is clearly different, for example, from patterns with regular orientations, such as stripes, wave-like stripes, and zigzags, and dot-like patterns. Such characteristics of the film-shaped mold allow its concave-convex cross-section to repeatedly appear, even when the film-shaped mold is cut in any directions perpendicular to the surface of the base member of the film-shaped mold. Further, a part or all of concave portions and convex portions of the concave-convex pattern may branch at their intermediate parts as viewed in a plan view. Each concave portion of the concave-convex pattern may be defined by each convex portion of the concave-convex pattern such that the concave portion extends along the convex portion. Fig. 10(a) depicts an exemplary AFM image of the concave-convex pattern, which is obtained by transferring the concave-convex pattern of the film-shaped mold described above. Fig. 10(b) depicts a cross-section profile taken along the cutting-plane line in the AFM image of Fig. 10(a). The concave-convex pattern, which is formed by transferring the concave-convex pattern of the film-shaped mold, has similar characteristics as the concave-convex pattern of the film-shaped mold. Namely, the formed concave-convex pattern has the cross-sectional shape of a wave-like structure and is characterized in that concave portions and convex portions having irregular lengths extend meanderingly or tortuously in irregular directions as viewed in a plan view.

It is preferred that the concave-convex pattern of the film-shaped mold be an irregular concave-convex pattern in which pitches of concavities and convexities are non-uniform and orientations of concavities and convexities have no directionality. The average pitch of the concavities and convexities can be, for example, in a range of 100 to 1,500 nm, and more preferably in a range of 200 to 1,200 nm. The average value of depth distribution of concavities and convexities is preferably in a range of 20 to 200 nm, and more preferably in a range of 30 to 150 nm. The standard deviation of depth of the convexities and concavities is preferably in a range of 10 to 100 nm, and more preferably in a range of 15 to 75 nm. The light(s) scattered and/or diffracted by such a concave-convex pattern is/are a light having a wavelength in a relatively broad band, rather than a light having a single wavelength or a light having a wavelength in a narrow band, and the scattered and/or diffracted light(s) have no directivity, and travel(s) in various directions.

Note that the term "average pitch of the concavities and convexities" means an average value of the pitch of concavities and convexities in a case of measuring the pitch of the concavities and convexities (spacing distance between adjacent convex portions or spacing distance between adjacent concave portions) in a surface on which the convexities and concavities are formed. Such an average value of the pitch of concavities and convexities is obtained as follows. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), under the following measurement conditions, then the distances between randomly selected concave portions or convex portions adjacent to each other are measured at not less than 100 points in the concavity and convexity analysis image, and then the average of the distances is calculated and is determined as the average value of the pitch of concavities and convexities.

The measurement conditions are as follows:

Measurement mode: cantilever intermittent contact mode
Material of the cantilever: silicon
Lever width of the cantilever: 40 $\mu$m
Diameter of tip of chip of the cantilever: 10 nm

Further, in the present application, the average value of the depth distribution of concavities and convexities and the standard deviation of depth of concavities and convexities which will be described later can be calculated by the following manner. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), in a randomly selected measurement region of 3 $\mu$m square (vertical: 3 $\mu$m, horizontal: 3 $\mu$m) or in a randomly selected measurement region of 10 $\mu$m square (vertical: 10 $\mu$m, horizontal: 10 $\mu$m) under the above-described conditions. When doing so, data of height of concavities and convexities at not less than 16,384 points (vertical: 128 points x horizontal: 128 points) are obtained within the measurement region, each in nanometer scale. Note that although the number of measurement points is different depending on the kind and setting of the measuring device which is used, for example in a case of using the above-described scanning probe microscope manufactured by Hitachi High-Tech Science Corporation, under the product name of "E-sweep", it is possible to perform the measurement at measurement points of 65,536 points (vertical: 256 points x horizontal: 256 points; namely, the measurement in a resolution of 256 x 256 pixels) within the measurement region of 3 $\mu$m square or 10 $\mu$m square. With respect to the height of concavities and convexities (unit: nm) measured in such a manner, at first, a measurement point "P" is determined, among all the measurement points, which is the highest from the surface of a transparent supporting substrate. Then, a plane which includes the measurement point P and which is parallel to the surface of the transparent supporting substrate is determined as a reference plane (horizontal plane), and a depth value from the reference plane (difference obtained by subtracting, from the value of height from the transparent supporting substrate at the measurement point P, the height from the transparent supporting substrate at each of the measurement points) is obtained as the data of depth of concavities and convexities. Note that such a depth data of the concavities and convexities can be obtained, for example, by performing automatic calculation with software in the measurement device (for example, the above-described scanning probe microscope manufactured by Hitachi High-Tech Science Corporation, under the product name of "E-sweep"), and the value obtained by the automatic calculation in such a manner can be utilized as the data of depth of concavities and convexities. After obtaining the data of depth of concavity and convexity at each of the measurement points in this manner, the values, which can be calculated by obtaining the arithmetic average value and the standard deviation of the obtained data of depth of concavity and convexity, are adopted as the average value of the depth distribution of concavities and convexities and the standard deviation of depth of concavities and convexities. In this specification, the average pitch of concavities and convexities, the average value of the depth distribution of concavities and convexities, and the standard deviation of depth of concavities and convexities can be obtained via the above-described measuring method, regardless of the material of the surface on which the concavities and convexities are formed.

After the mold is pressed against the base material layer, the base material layer may be subjected to pre-baking. The pre-baking promotes gelation of the base material layer to solidify the pattern, which allows the pattern to be less likely to be collapsed during releasing or peeling. When the pre-baking is performed, heating is preferably performed at temperatures of 40 to 150°C in the atmosphere. It is not indispensable to perform the pre-baking.

After the pressing with the mold or the pre-baking for the base material layer, the mold is released or peeled off from the base material layer. As the method for releasing the mold, any known releasing method can be adopted. The mold may be released while being heated. In this case, gas generated from the base material layer is allowed to escape, thereby preventing generation of bubbles in the base material layer. In the roll process, the releasing force (peeling force) may be smaller than that in the pressing system using a plate-shaped mold, and it is possible to easily release the mold from the base material layer without remaining the base material layer on the mold. In particular, since the pressing is performed while the base material layer is being heated, reaction is more likely to progress, which facilitates the releasing of the mold from the base material layer immediately after the pressing. In order to improve the releasing property (peeling property) of the mold, it is possible to use a peeling roll (releasing roll). As depicted in Fig. 2, a peeling roll (releasing roll) 123 disposed on the downstream side of a pressing roll 122 rotates and supports a film-shaped mold 50 while urging the film-shaped mold 50 toward the base material layer 12. This can maintain a state in which the film-shaped mold 50 is attached to the base material layer (coating film) 12 by a distance between the pressing roll 122 and the peeling roll 123 (for a certain period of time). Then, a path of the film-shaped mold 50 is changed so that the film-shaped mold 50 is pulled up above the peeling roll 123 on the downstream side of the peeling roll 123, thereby peeling off (releasing) the film-shaped mold 50 from the base material layer 12 in which concavities and convexities are formed. The pre-baking or the heating for the base material layer 12 may be performed during a period in which the film-shaped mold 50 is attached to the base material layer 12. When the peeling roll 123 is used, the releasing of the mold 50 becomes easier by releasing the mold 50 from the base material layer 12 while heating the base material layer 12, for example, at temperatures of 40 to 150°C.

After the mold is released from the base material layer, the base material layer may be cured. Accordingly, the base layer 13 having the concave-convex pattern as depicted in Fig. 1(b) is formed. In this embodiment, the base material layer made of the sol-gel material can be cured by main baking. The hydroxyl group or the like contained in silica (amorphous silica) constructing the base material layer (coating film) is desorbed or eliminated (subjected to the leaving) by the main baking, and the base material layer is further hardened or solidified. The main baking is preferably performed at a temperature in a range of 200 to 1200°C for a duration of time in a range of about 5 minutes to about 6 hours. In such a manner, the base material layer is cured, and the base layer 13 having the concave-convex pattern which corresponds to the concave-convex pattern of the mold is formed. When the base layer 13 is made of silica, silica is amorphous, crystalline, or in a mixture state of the amorphous and the crystalline, depending on the baking temperature and the baking time. When a material, which generates an acid or alkali by irradiation with light such as ultraviolet rays, is added to the sol-gel material solution, a step of curing the base material layer, in which the base material layer is cured by irradiation with energy rays represented by ultraviolet rays such as excimer UV light, may be included in the concave-convex pattern transfer process.

An explanation will be made about an exemplary method for producing the film-shaped mold for the concave-convex pattern transfer which is suitably used for the step of forming the base layer. A master block pattern for forming the concave-convex pattern of the mold is manufactured first. It is preferred that the concave-convex pattern of the master block be formed by a method of utilizing the self-organization or self-assembly (micro phase separation) of a block copolymer by heating, as described in International Publication No. WO2012/096368 of the applicants of the present invention (hereinafter referred to as "BCP (Block Copolymer) thermal annealing method" as appropriate), a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate), or a method of utilizing the self-organization or self-assembly of a block copolymer under a solvent atmosphere (hereinafter referred to as "BCP solvent annealing method" as appropriate) which will be described below. The photolithography method may be utilized instead of the BCP thermal annealing method, BKL method, and BCP solvent annealing method. In addition to the above methods, the concave-convex pattern of the master block can be manufactured by, for example, microfabrication or fine-processing methods including a cutting (cutting and processing) or machining method, an electron-beam direct imaging method, a particle beam processing method, a scanning probe processing method, and a fine-processing method using the self-organization or self-assembly of fine particles, etc. When the pattern is formed by the BCP thermal annealing method, although the pattern made of any material can be used, the material is preferably a block copolymer composed of a combination of two selected from the group consisting of a styrene-based polymer such as polystyren; polyalkyl methacrylate such as polymethyl methacrylate; polyethylene oxide; polybutadiene; polyisoprene; polyvinylpyridine; and polylactic acid.

The BCP solvent annealing method is a method including following steps instead of the first heating step, the etching step and the second heating step in the BCP thermal annealing method described in WO2012/096368. Namely, a thin film of the block copolymer which has been applied on a substrate and dried is subjected to a solvent annealing (solvent phase separation) process under an atmosphere of vapor of an organic solvent to form a phase separation structure of the block copolymer in the thin film,. With this solvent annealing process, the self-organization of the block copolymer is advanced, and the block copolymer undergoes the micro phase separation into the concave-convex structure.

For example, the solvent annealing process can be carried out by providing the atmosphere of vapor of the organic solvent inside a tightly sealable container such as a desiccator, and exposing the thin film of the block copolymer as the objective under this atmosphere. The concentration of vapor of the organic solvent is preferably high for the purpose of promoting the phase separation of the block copolymer, in particular, it is preferred that the concentration of the organic solvent vapor be a concentration in which the pressure of the organic solvent vapor is saturated, wherein not only the phase separation of the block copolymer is promoted but also the concentration of the organic solvent vapor can be controlled or managed relatively easily. For example, when the organic solvent is chloroform, the saturated vapor amount (quantity) is known to be in a range of 0.4 to 2.5 g/l at room temperature (0 to 45°C). If the time of the organic solvent annealing process using chloroform or the like is excessively long, there is such a tendency that polyethylene oxide is deposited on the surface of the coating film and/or the concave-convex shape formed by the phase separation is collapsed (loosened). The treatment time of the solvent annealing process may be 6 to 168 hours, preferably 12 to 48 hours, and more preferably 12 to 36 hours.

The organic solvent used in the solvent annealing process is preferably an organic solvent of which boiling point is in a range of 20 to 120°C. It is possible to use, for example, chloroform, dichloromethane, toluene, tetrahydrofuran (THF), acetone, carbon disulfide, and mixture solvents thereof. Among these solvents, chloroform, dichloromethane, acetone, and or a mixture solvent of acetone/carbon disulfide are preferable. It is preferred that the solvent annealing process be performed at an atmosphere temperature in a range of 0 to 45°C.

It is allowable to perform the heating process to the concave-convex structure of the thin film obtained by the solvent annealing process. The concave-convex structure has been already formed by the solvent annealing process. Therefore, the heating process loosens or smooths the formed concave-convex structure, but the heating process is not necessarily indispensable. The heating process may be effective when any protrusion is formed on a part of the surface of the concave-convex structure after the solvent annealing process on account of any cause or when it is intended to adjust the cycle (period or pitch) and/or the height of the concave-convex structure. For example, the heating temperature can be not less than the glass transition temperatures of the polymer segments constituting the block copolymer. For example, the heating temperature can be not less than the glass transition temperatures of the homopolymers and not more than a temperature higher than the glass transition temperatures by 70°C. The heating process can be performed in the atmosphere of the atmospheric air by using, for example, an oven. Further, the concave-convex structure of the thin film obtained by the solvent annealing process may be subjected to etching by irradiation with energy rays represented by ultraviolet rays such as excimer UV light, or etching by a dry etching method such as reactive ion etching (RIE). The concave-convex structure of the thin film which has been subjected to the etching may be subjected to the heating process.

After forming the master block with the pattern by means of the BCP thermal annealing method, BKL method, or BCP solvent annealing method, further, a mold to which the pattern is transferred can be formed by an electroforming method or the like, as follows. At first, a seed layer functioning as an electroconductive layer for an electroforming process can be formed on the master block, which has the pattern to be transferred, by means of non-electrolytic plating, sputtering, vapor deposition, or the like. The thickness of the seed layer is preferably not less than 10 nm to uniformize a current density during the subsequent electroforming process, and thereby making the thickness of a metal layer accumulated by the subsequent electroforming process uniform. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof. Subsequently, a metal layer is accumulated on the seed layer by the electroforming (electroplating). The entire thickness of the metal layer including the thickness of the seed layer can be, for example, in a range of 10 to 3000 $\mu$m. As the material of the metal layer accumulated by the electroforming, it is possible to use any of metal species as described above which can be used as the seed layer. Considering ease of the subsequent processes for forming the mold such as pressing to the resin layer, releasing, and cleaning, the formed metal layer desirably has appropriate hardness and thickness.

The metal layer including the seed layer obtained as described above is released (peeled off) from the master block having the concave-convex structure to obtain a metal substrate. As the releasing method, the metal layer may be peeled off physically, or the materials composing the pattern of the master block may be dissolved to be removed by using an organic solvent dissolving them, such as toluene, tetrahydrofuran (THF), and chloroform. When the metal substrate is peeled off from the master block, a remaining material component on the metal substrate can be removed by cleaning. As the cleaning method, it is possible to use wet cleaning using a surfactant etc., or dry cleaning using ultraviolet rays and/or plasma. Alternatively, for example, the remaining material component may be attached to or adhere to an adhesive agent or a bonding agent then be removed. Accordingly, the metal substrate to which the pattern has been transferred from the master block can be obtained.

The base layer 13 having the concave-convex pattern can be formed by using the obtained metal substrate as the mold for concave-convex pattern transfer and transferring the concave-convex pattern of the mold to the base material layer. Further, a flexible mold such as the film-shaped mold can be manufactured by transferring the concave-convex structure (pattern) of the obtained metal substrate to a film-shaped supporting substrate. For example, after the supporting substrate is coated with a curable resin, the resin layer is cured while the concave-convex structure of the metal substrate is being pressed against the resin layer. The supporting substrate is exemplified, for example, by base members made of inorganic materials such as glass; base members made of organic materials such as silicon resin, polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate; and metallic materials such as nickel, copper, and aluminium. The thickness of the supporting substrate may be in a range of 1 to 500 $\mu$m.

The curable resin can be exemplified by various resins based on epoxy, acrylic, methacrylic, vinyl ether, oxetane, urethane, melamine, urea, polyester, phenol, cross-linking type liquid crystal, fluorine, silicone, etc. The thickness of the curable resin is preferably in a range of 0.5 to 500 $\mu$m. When the thickness is less than the lower limit, heights of concavities and convexities formed on the surface of the cured resin layer are likely to be insufficient. When the thickness exceeds the upper limit, the influence of volume change of the resin upon curing is likely to be so large that formation of the shape of concavities and convexities is liable to be unsatisfactory.

As a method for coating the supporting substrate with the curable resin, for example, it is possible to adopt various coating methods such as the spin coating method, spray coating method, dip coating method, dropping method, gravure printing method, screen printing method, relief printing method, die coating method, curtain coating method, ink-jet method, and sputtering method. Further, the condition for curing the curable resin depends on the kind of the resin to be used. For example, the curing temperature is preferably in a range of room temperature to 250°C, and the curing time is preferably in a range of 0.5 minute to 3 hours. Alternatively, a method may be employed in which the curable resin is cured by being irradiated with energy rays such as ultraviolet light or electron beams. In such a case, the amount of the irradiation is preferably in a range of 20 mJ/cm$^2$ to 5 J/cm$^2$.

Subsequently, the metal substrate is detached from the curable resin layer after the curing. The method for detaching the metal substrate is not limited to a mechanical releasing (exfoliating or peeling off) method, and any known method can be adopted. Accordingly, it is possible to obtain a mold having the cured resin layer in which concavities and convexities are formed on the supporting substrate.

[Formation of coating layer]

Subsequently, a sol-gel material solution as a coating material is prepared. It is possible to use, as the coating material, a material similar to the sol-gel material which can be used as the base material. It is especially preferred that the same material as is used as the base material be used as the coating material. When the coating material and the base material are composed of the same material, reflection of light at an interface between the base layer and the coating layer can be prevented.

As a solvent of the sol-gel material solution used as the coating material, it is possible to use a solvent similar to the solvent which can be used in the base material. As an additive of the sol-gel material solution used as the coating material, it is possible to use an additive similar to the additive which can be used in the base material. It is preferred that a diluted solution, which is diluted with a solvent to be weaker than the sol-gel material solution as the base material, be used as the sol-gel material solution as the coating material. Namely, it is preferred that the sol-gel material solution as the coating material have a concentration lower than that of the sol-gel material solution as the base layer. In such a case, the coating layer having a predetermined thickness which is thinner than the base layer can be easily formed.

As depicted in Fig. 1(c), a coating layer 14 is formed by coating the concave-convex pattern surface of the base layer 13 with the sol-gel material solution, which has been prepared as the coating material in the above manner. Before formation of the coating layer, the substrate with the base layer 13 may be cleaned. The cleaning method is exemplified, for example, by wet cleaning such as ultrasonic cleaning in an organic solvent or water, dry cleaning such as a UV ozone treatment, and the combination of wet cleaning and dry cleaning. The thickness of the coating layer 14 is in a range of 25 to 150% of standard deviation $\sigma1$ of depth of convexities and concavities of the base layer 13. The base layer 13, which is formed by transferring the concave-convex pattern of the mold, may have a defect of the concave-convex pattern due to a pattern defect of the mold, exfoliation of the base material layer at the time of mold releasing, adhesion of foreign substances, a crack caused by baking of the base material layer, and the like. Coating the concave-convex pattern surface of the base layer 13 with the coating material to form the coating layer 14 having a thickness in the above range can compensate or fill the defect of the concave-convex pattern in the surface of the base layer 13. When a substrate 100 with the concave-convex structure according to this embodiment is used for the organic EL element, the coating layer 14 formed to have a thickness in the above range on the base layer 13 can compensate or repair the defect of concave-convex pattern, which may otherwise be caused in the surface of the base layer 13, thereby preventing the occurrence of leak current in the organic EL element. When the thickness of the coating layer 14 is less than 25% of the standard deviation $\sigma1$ of depth of convexities and concavities of the base layer 13, the coating layer 14 can not sufficiently compensate or repair the defect in the surface of the base layer 13. When the thickness of the coating layer 14 exceeds 150% of the standard deviation $\sigma1$ of depth of convexities and concavities of the base layer 13, the surface of the coating layer 14 is nearly flat. Thus, the substrate with the concave-convex structure is less likely to function as the diffraction grating, and light extraction efficiency-enhancing effect obtained therefrom is insufficient.

Note that, it is not easy to measure the thickness of the coating layer formed on the concave-convex pattern surface. Thus, the thickness of the coating layer in the present application is regarded as the thickness of a coating film formed by coating a flat and smooth substrate with the coating material under the same conditions as those for forming the coating layer. The thickness of the coating film on the flat and smooth substrate can be measured by an ellipsometer or the like. Further, the thickness of the coating film can be measured as follows. That is, a part (area) with no coating film is formed on the flat and smooth substrate by forming the coating film on the flat and smooth substrate provided with a mask and then removing the mask, or by removing a part of the formed coating film. Then, the difference in level between the part with the coating film and the part with no coating film is measured by a three-dimensional roughness meter or the like. When the material of the coating layer is different from that of the base layer, the thickness of the coating layer can be measured by a cross-section observation by using a transmission electron microscope (TEM) or the like.

From a viewpoint of mass-production, it is preferred that the substrate be coated with the coating material at a predetermined position while a plurality of substrates are continuously transported. As the coating method, it is possible to use any coating method such as a bar coating method, a spin coating method, a spray coating method, a dip coating method, a die coating method, and an ink-jet method. The die coating method, the bar coating method, and the spin coating method are preferable, because the substrate having a relatively large area can be coated uniformly with the coating material and the coating can be quickly completed prior to gelation of the sol-gel material solution as the coating material.

The coating layer 14 may be subjected to pre-baking after the coating layer 14 is formed by coating the concave-convex pattern surface of the base layer 13 with the coating material. The pre-baking promotes gelation of the coating layer 14. When the pre-baking is performed, heating is preferably performed at temperatures of 40 to 150°C in the atmosphere.

Subsequently, the coating layer 14 may be cured. In this embodiment, the coating layer 14 made of the sol-gel material can be cured by main baking. The hydroxyl group and the like contained in the sol-gel material layer, such as silica, constituting the coating layer 14 is desorbed or eliminated by the main baking to further harden (solidify) the coating layer 14. It is preferred that the main baking be performed at temperatures of 200 to 1,200°C for about 5 minutes to about 6 hours. The coating layer 14 can be cured, accordingly. In this situation, when the coating layer 14 is made of silica, the coating layer 14 is amorphous, crystalline, or in a mixture state of the amorphous and the crystalline, depending on the baking temperature and baking time. The thickness of the coating layer 14 is smaller than that of the base layer 13.

Thus, unlike the base layer 13, the coating layer 14 is less likely to have a crack and the like which would be otherwise caused by expansion or contraction at the time of baking. When a material, which generates an acid or alkali by irradiation with light such as ultraviolet rays, is added to the sol-gel material solution, a step of curing the coating layer 14, in which the coating layer 14 is cured by irradiation with energy rays represented by ultraviolet rays such as excimer UV light, may be performed after the coating step using the coating material.

Further, a hydrophobization treatment may be performed on the surface of the coating layer 14. Any known method for the hydrophobization treatment may be used. For example, regarding the surface of silica, the hydrophobization treatment can be performed with dimethyl dichlorosilane, trimethyl alkoxysilan, etc., or with a silicone oil and a trimethylsilylating agent such as hexamethyl-disilazane. Alternatively, it is also allowable to employ a surface treatment method for a surface of metal oxide powder with supercritical carbon dioxide. When the substrate 100, which is manufactured by the manufacturing method in the embodiment to include the coating layer 14 of which surface has hydrophobicity, is used in the manufacture of a device such as the organic EL element, moisture can be easily removed from the substrate during the manufacturing process of the device. Thus, the organic EL element is prevented from suffering from the defect, such as dark spots, and the deterioration thereof.

The concave-convex pattern in the surface of the coating layer 14 formed as described above may be any pattern such as a micro lens array structure or a structure having the light diffusion function, light diffraction function, etc. Especially, the concave-convex pattern is preferably, for example, an irregular concave-convex pattern in which pitches of concavities and convexities are non-uniform and the orientations of the concavities and convexities have no directionality. The light(s) scattered and/or diffracted by such a concave-convex pattern layer is/are a light having a wavelength in a relatively broad band, rather than a light having a single wavelength or a light having a wavelength in a narrow band, and the scattered and/or diffracted light(s) have no directivity, and travel(s) in various directions. Note that, however, the term "irregular concave-convex pattern" includes such a quasi-periodic structure in which a Fourier-transformed image, obtained by performing a two-dimensional fast Fourier-transform processing on a concavity and convexity analysis image obtained by analyzing a concave-convex shape on the surface, shows a circular or annular pattern, namely, such a quasi-periodic structure in which, although the concavities and convexities have no particular orientation (directionality), the structure has the distribution of the pitches of concavities and convexities (the pitches of the concavities and convexities vary).

The average pitch of the concave-convex pattern in the surface of the coating layer 14 formed as described above may be, for example, in a range of 100 to 1500 nm, more preferably in a range of 200 to 1200 nm. When the average pitch of the concavities and convexities is less than the lower limit, the pitches are so small relative to wavelengths of the visible light that the diffraction of light by the concavities and convexities is likely to be insufficient. When the average pitch exceeds the upper limit, a diffraction angle is so small that functions as an optical element such as the diffracting grating are more likely to be lost. The average value of the depth distribution of the concavities and convexities is preferably in a range of 20 to 200 nm, more preferably in a range of 30 to 150 nm. The standard deviation of depth of convexities and concavities is preferably in a range of 10 to 100 nm, more preferably in a range of 15 to 75 nm.

In this embodiment, in order to express the concave-convex shape in the surface of the formed coating layer 14, i.e., the degree of concavities and convexities (depth), there is used the ratio of the standard deviation of depth of concavities and convexities in the surface of the coating layer 14 (hereinafter referred to as "second concave-convex depth" as appropriate) with respect to the standard deviation of depth of concavities and convexities in the surface of the base layer 13 (hereinafter referred to as "first concave-convex depth" as appropriate). This ratio is appropriately referred as "shape maintenance ratio" (or "shape retention ratio") in this specification. That is, the shape maintenance ratio W is represented by the following formula:

$$W = \sigma 2/\sigma 1$$

in the formula, $\sigma 1$ is the standard deviation of the first concave-convex depth and $\sigma 2$ is the standard deviation of the second concave-convex depth.

As will be explained in Examples, the shape maintenance ratio W correlates with the ratio of thickness of the coating layer to the standard deviation $\sigma 1$ of the first concave-convex depth. There is such a tendency that the shape maintenance ratio W is smaller, as the ratio of thickness of the coating layer to the standard deviation $\sigma 1$ of the first concave-convex depth is greater, and that the shape maintenance ratio W is greater, as the ratio of thickness of the coating layer to the standard deviation $\sigma 1$ of the first concave-convex depth is smaller.

In this embodiment, the coating layer is formed such that the thickness of the coating layer is in a range of 25 to 150% of the standard deviation $\sigma 1$ of the first concave-convex depth as described above. This allows the shape maintenance ratio W to be in a range of 50 to 95%. When the thickness of the coating layer is not more than 150% of the standard deviation $\sigma 1$ of the first concave-convex depth, the shape maintenance ratio W is not less than 50%. In this case, the substrate with the concave-convex structure manufactured by the manufacturing method according to this embodiment has the function as the diffraction grating. However, when the thickness of the coating layer exceeds 150% of the standard deviation $\sigma 1$ of the first concave-convex depth, the shape maintenance ratio W is less than 50%. In this case, the surface of the coating layer is nearly flat and the substrate with the concave-convex structure is less likely to function as the diffraction grating. When the thickness of the coating layer is less than 25% of the standard deviation $\sigma 1$ of the first concave-convex depth, i.e., when the shape maintenance ratio W exceeds 95%, the thickness of the coating layer is so small that the coating layer can not compensate or fill the defect in the surface of the base layer sufficiently. Thus, when the organic EL element is manufactured by using this substrate, leak current due to the defect is liable to occur. When the coating layer is formed such that the thickness of the coating layer is in a range of 25 to 100% of the standard deviation $\sigma 1$ of the first concave-convex depth, i.e., such that the shape maintenance ratio W is in a range of 70 to 95%, the light extraction efficiency obtained by the concave-convex pattern of the substrate becomes considerably higher. Further, the thickness of the coating layer has an influence on multiple interference caused in the stacked structure of the organic EL element. Thus, the thickness of the coating layer may be adjusted appropriately to optimize or shift the position of peak wavelength of light extracted from the substrate.

As described above, the substrate 100 with the concave-convex structure as depicted in Fig. 1(c) is manufactured by the manufacturing method according to this embodiment.

As the base material and the coating material, it is allowable to use a sol-gel material solution such as $TiO_2$, ZnO, ZnS, ZrO, $BaTiO_3$, or $SrTiO_2$, or a dispersion liquid of fine particles made of a material such as $TiO_2$, ZnO, ZnS, ZrO, $BaTiO_3$, or $SrTiO_2$. Of the above materials, $TiO_2$ is preferably used in view of the film formation performance (coating property) and the refractive index. In addition to the above coating methods, the coating may be performed by a liquid phase deposition (LPD).

Alternatively, a polysilazane solution may be applied as the base material and coating material. In this case, the curing of base material layer and coating layer can be performed by forming these layers into ceramic (silica reforming or modification). It is noted that "polysilazane" is a polymer having a silicon-nitrogen bond, is an inorganic polymer comprising Si-N, Si-H, N-H, or the like, and is a precursor of a ceramics such as $SiO_2$, $Si_3N_4$, or $SiO_xN_y$, which is an intermediate solid solution of them. A compound, which is ceramized at relatively low temperature and is modified into silica, is more preferred. For example, a compound, which is represented by the following formula (1) described in Japanese Patent Application Laid-open No. H8-112879, is more preferable.

Formula (1): -Si (R1) (R2)-N (R3)-

In the formula (1), R1, R2, and R3 each represent a hydrogen atom, an alkyl group, an alkenyl group, a cycloalkyl group, an aryl group, an alkylsilyl group, an alkylamino group, or an alkoxy group.

Of the compounds represented by the formula (1), perhydropolysilazane (referred to also as PHPS) in which all of R1, R2, and R3 are hydrogen atoms and organopolysilazane in which a part of the hydrogen bonded to Si thereof is substituted by, for example, an alkyl group are particularly preferred.

Other examples of the polysilazane ceramized at low temperature include: silicon alkoxide-added polysilazane obtained by reacting polysilazane with silicon alkoxide (for example, Japanese Patent Laid-Open No. 5-238827); glycidol-added polysilazane obtained by reaction with glycidol (for example, Japanese Patent Laid-open No. 6-122852); alcohol-added polysilazane obtained by reaction with alcohol (for example, Japanese Patent Laid-open No. 6-240208); metal carboxylate-added polysilazane obtained by reaction with metal carboxylate (for example, Japanese Patent Laid-Open No. 6-299118); acetylacetonato complex-added polysilazane obtained by reaction with an acetylacetonato complex containing a metal (for example, Japanese Patent Laid-Open No. 6-306329); metallic fine particles-added polysilazane obtained by adding metallic fine particles (for example, Japanese Patent Laid-Open No. 7-196986), and the like.

As the solvent of the polysilazane solution, it is possible to use hydrocarbon solvents such as aliphatic hydrocarbons, alicyclic hydrocarbons, and aromatic hydrocarbons; halogenated hydrocarbon solvents; and ethers such as aliphatic ethers and alicyclic ethers. Amine or a metal catalyst may be added in order to promote the modification into a silicon oxide compound.

In the above embodiment, the base layer 13 is formed by using the sol-gel material as the base material. A curable resin material, however, may be used instead of the inorganic material. The curable resin can be exemplified by resins such as photosetting resins, thermosetting resins, moisture curing type resins, chemical curing type resins (two-liquid mixing type resins), etc. Specifically, the curable resin can be exemplified by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, polyamide, etc.

When the base layer 13 is formed by using the curable resin as the base material, the concave-convex pattern of the mold can be transferred to the curable resin layer by, for example, the following manner. Namely, the substrate is coated with the curable resin, and then the coating film (curable resin layer) is cured while the mold having a fine concave-convex pattern is being pressed against the curable resin layer. The curable resin may be applied after being diluted with an organic solvent. As the organic solvent used in this case, an organic solvent, which dissolves the resin to be cured, can be selected and used. For example, it is possible to select the organic solvent from among known organic solvents including, for example, alcohol-based solvents such as methanol, ethanol, and isopropyl alcohol (IPA); and ketone-based solvents such as acetone, methyl ethyl ketone, and methyl isobutyl ketone (MIBK). As a method for applying the curable resin, for example, it is possible to adopt various coating methods such as the spin coating method, spray coating method, dip coating method, dropping method, gravure printing method, screen printing method, relief printing method, die coating method, curtain coating method, ink-jet method, and sputtering method. As the mold having the fine concave-convex pattern, it is possible to use a desired mold such as the film-shaped mold or metal mold. Further, the condition for curing the curable resin depends on the kind of the resin to be used. For example, the curing temperature is preferably in a range of room temperature to 250°C, and the curing time is preferably in a range of 0.5 minute to 3 hours. Alternatively, a method may be employed in which the curable resin is cured by being irradiated with energy rays such as ultraviolet light or electron beams. In such a case, the amount of the irradiation is preferably in a range of 20 mJ/cm$^2$ to 5 J/cm$^2$.

The coating layer 14 may be formed by using a curable resin material as the coating material as in the case in the base layer 13. Like the base material, the curable resin can be exemplified by resins such as photosetting resins, thermosetting resins, moisture curing type resins, chemical curing type resins (two-liquid mixing type resins), etc. Specifically, the curable resin can be exemplified by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, polyamide, etc.

When the coating layer 14 is formed by using the curable resin as the coating material, the coating layer 14 can be formed by coating the base layer 13 with the curable resin, and then curing the curable resin with which the base layer 13 is coated. The curable resin may be applied after being diluted with an organic solvent. As the organic solvent used in this case, an organic solvent, which dissolves the resin to be cured, can be selected and used as in a case in the base material. For example, it is possible to select the organic solvent from among known organic solvents including, for example, alcohol-based solvents such as methanol, ethanol, and isopropyl alcohol (IPA); and ketone-based solvents such as acetone, methyl ethyl ketone, and methyl isobutyl ketone (MIBK). It is preferred that the coating material be identical to the base material. In this case, it is preferred that a diluted solution, which is diluted with a solvent to be weaker than the solution of curable resin used as the base material, be used as the coating material. Namely, it is preferred that the solution of curable resin as the coating material have a concentration lower than the solution of curable resin as the base material. In such a case, the coating layer can be easily formed to have a predetermined thickness. As a method for applying the curable resin, for example, it is possible to adopt various coating methods such as the spin coating method, spray coating method, dip coating method, dropping method, gravure printing method, screen printing method, relief printing method, die coating method, curtain coating method, ink-jet method, and sputtering method. The condition for curing the curable resin depends on the kind of the resin to be used. For example, the curing temperature is preferably in a range of room temperature to 250°C, and the curing time is preferably in a range of 0.5 minute to 3 hours. Alternatively, a method may be employed in which the curable resin is cured by being irradiated with energy rays such as ultraviolet light or electron beams. In such a case, the amount of the irradiation is preferably in a range of 20 mJ/cm$^2$ to 5 J/cm$^2$.

A silane coupling agent may be used as the coating material. When the organic EL element is produced by using the substrate 100 with the concave-convex structure according to the embodiment, the use of the silane coupling agent can improve the adhesion property between the coating layer 14 and a layer, such as an electrode, to be formed on the coating layer 14. This develops the resistance in the cleaning step and the high temperature treatment step included in the production process of the organic EL element. The type of silane coupling agent used for the coating layer 14 is not especially limited. As the silane coupling agent, it is possible to use, for example, an organic compound represented by RSiX$_3$ (R is an organic functional group containing at least one selected from a vinyl group, a glycidoxy group, an acrylic group, a methacryl group, an amino group, and a mercapto group, and X is a halogen element or an alkoxyl group). As the method for applying the silane coupling agent, it is possible to employ various coating methods including, for example, a spin coating method, a spray coating method, a dip coating method, a dropping method, a gravure printing method, a screen printing method, a relief printing method, a die coating method, a curtain coating method, an ink-jet method, and a sputtering method. Then, the coating material is dried under a proper condition depending on the material used, thereby the cured film can be obtained. For example, the coating material may be heat-dried at temperatures of 100 to 150 degrees Celsius for 15 to 90 minutes.

The base material and/or the coating material may be that (those) obtained by mixing an inorganic material or a curable resin material with an ultraviolet absorbent material. The ultraviolet absorbent material has the function or effect to prevent deterioration of the film by absorbing ultraviolet rays and converting light energy into something harmless such as heat. Any known agent may be used as the ultraviolet absorbent material. Those usable as the ultraviolet absorbent material include, for example, benzotriazole-based absorbents, triazine-based absorbents, salicylic acid derivative-based absorbents, and benzophenone-based absorbents.

The substrate 100 with the concave-convex structure, in which the base layer 13 and the coating layer 14 are stacked on the substrate 10 in that order, as depicted in Fig. 1(c) is manufactured by the method for manufacturing the substrate with the concave-convex structure according to the embodiment.

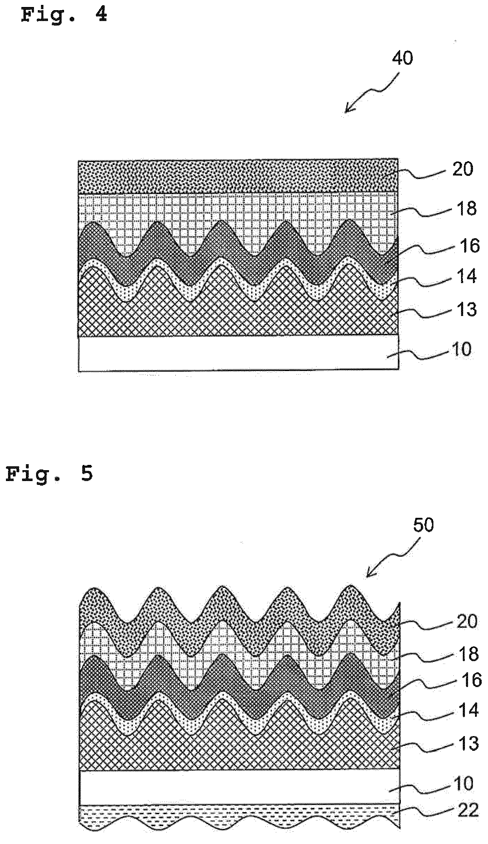

Subsequently, an explanation will be made about the organic EL element manufactured by using the substrate with concave-convex structure according to the embodiment. As depicted in Figs. 3 and 4, in organic EL elements 30, 40 according to the embodiment, a first electrode layer 16, an organic layer 18, and a second electrode layer 20 are stacked, in that order, on the substrate 100 with the concave-convex structure formed of the substrate 10, the base layer 13, and the coating layer 14.

[First electrode]

The first electrode 16 is formed on the coating layer 14. The first electrode 16 has a transmissive ability or permeability to allow the light from the organic layer 18 formed on the first electrode 16 to pass toward the substrate side. Therefore, the first electrode 16 is also referred to as a transparent electrode. As the electrode material of the first electrode 16, for example, indium oxide, zinc oxide, tin oxide, indium-tin oxide (ITO) which is a composite material thereof, gold, platinum, silver, or copper can be used. Of these materials, ITO is preferable from the viewpoint of transparency and electrical conductivity.

As the method for forming the first electrode 16, any known method such as a vapor deposition method, a sputtering method, a CVD method, and a spray method can be employed as appropriate. Of these methods, the sputtering method is preferably employed from the viewpoint of improving the adhesion property. After forming the film of an electrode material layer by the sputter method or the like, a desired electrode pattern can be formed by a photolithography process (photoetching method).

The first electrode 16 may have an actual thickness ranging from 80 to 200 nm or an optical thickness ranging from 160 to 400 nm. In the present invention, when the thickness exceeds the upper limit, there is fear that the concave-convex pattern formed in the surface of the coating layer 14 may not be maintained in the surface of the first electrode 16 depending on depth of concavities and convexities of the coating layer 14. Like the coating layer 14, the thickness of the first electrode layer 16 has an influence on the multiple interference caused in the stacked structure of the organic EL element. Thus, in order to optimize the position of peak wavelength of light extracted from the substrate, the thickness of the first electrode layer 16 may be adjusted together with or independently from the coating layer 14. In the present description, the thickness means the actual thickness unless noted as the optical thickness.

[Organic layer]

The organic layer 18 is not particularly limited, provided that the organic layer 18 is usable as an organic layer of the organic EL element. As the organic layer 18, any known organic layer can be used as appropriate. The organic layer 18 may be a stacked body of various organic thin films. For example, the organic layer 18 may be a stacked body of a hole transporting layer, a light-emitting layer, and an electron transporting layer. Examples of materials of the hole transporting layer include aromatic diamine compounds such as phthalocyanine derivatives, naphthalocyanine derivatives, porphyrin derivatives, N,N'-bis(3 -methylphenyl)-(1,1'-biphenyl)-4,4'-diamine (TPD), and 4,4'-bis[N-(naphthyl)-N-phenyl-amino]biphenyl($\alpha$-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino)triphenylamine (m-MTDATA). The materials of the hole transporting layer, however, are not limited thereto.

By providing the light emitting layer, a hole injected from the first electrode 16 and electron injected from the second electrode 20 are recombined to occur light emission. Examples of materials of the light emitting layer include metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Further, it is preferred that light-emitting materials selected from the above compounds be mixed as appropriate and then used. Furthermore, it is possible to preferably use a material system generating emission of light from a spin multiplet, such as a phosphorescence emitting material generating emission of phosphorescence and a compound including, in a part of the molecules, a constituent portion formed by the above materials. The phosphorescence emitting material preferably includes heavy metal such as iridium. A host material having high carrier mobility may be doped with each of the light-emitting materials as a guest material to generate the light emission using dipole-dipole interaction (Forster mechanism), or electron exchange interaction (Dexter mechanism). Examples of materials of the electron transporting layer include heterocyclic tetracarboxylic anhydrides such as nitro-substituted fluorene derivatives, diphenylquinone derivatives, thiopyran dioxide derivatives, and naphthaleneperylene; and metallo-organic complex such as carbodiimide, fluorenylidene methane derivatives, anthraquino dimethane and anthrone derivatives, oxadiazole derivatives, and aluminum-quinolinol complex (Alq3). Further, in the oxadiazole derivatives mentioned above, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecular chain. It is noted that the hole transporting layer or the electron transporting layer may also function as the light-emitting layer. In this case, there are two organic layers 18 between the first electrode 16 and the second electrode 20.

From the viewpoint of facilitating the electron injection from the second electrode 20, it is allowable to provide, between the organic layer 18 and the second electrode 20, as an electron injecting layer, a layer made of a metal fluoride such as lithium fluoride (LiF), a metal oxide such as $Li_2O_3$, a highly active alkaline earth metal such as Ca, Ba, or Cs, an organic insulating material, or the like. Further, from the viewpoint of facilitating the hole injection from the first electrode 16, it is allowable to provide, between the organic layer 18 and the first electrode 16, as the hole injecting layer, a layer made of triazole derivatives; oxadiazole derivatives; imidazole derivatives; polyarylalkane derivatives; pyrazoline derivatives and pyrazolone derivatives; phenylenediamine derivatives; arylamine derivatives; amino-substituted chalcone derivatives; oxazole derivatives; styrylanthracene derivatives; fluorenon derivatives; hydrazone derivatives; stilbene derivatives; silazane derivatives; aniline copolymer; or a conductive polymer oligomer, in particular, thiophene oligomer, or the like.

When the organic layer 18 is a stacked body formed of the hole transporting layer, the light-emitting layer, and the electron transporting layer, the thicknesses of the hole transporting layer, the light-emitting layer, and the electron transporting layer are preferably in a range of 1 to 200 nm, in a range of 5 to 100 nm, and in a range of 5 to 200 nm, respectively. As a method for stacking the organic layer 18, any known method such as a vapor deposition method, a sputtering method, a spin coating method, and a die coating method can be employed as appropriate.

As depicted in Fig. 3, the surface of the organic layer 18 may be formed to maintain the concave-convex pattern formed on the surface of the coating layer 14. As depicted in Fig. 4, the surface of the organic layer 18 may be flat without maintaining the concave-convex pattern formed on the surface of the coating layer 14. When the surface of the organic layer 18 is formed to maintain the concave-convex pattern formed on the surface of the coating layer 14, plasmon absorption due to the second electrode is reduced to improve light extraction efficiency.

[Second electrode]

The second electrode 20 as a metal electrode is provided on the organic layer 18. Materials of the second electrode 20 are not particularly limited, and a substance having a small work function can be used as appropriate. Examples of materials of the second electrode 20 include aluminum, MgAg, MgIn, and AlLi. The thickness of the second electrode 20 is preferably in a range of 50 to 500 nm. Any known method such as a vapor deposition method and a sputtering method can be adopted to stack the second electrode 20. Accordingly, the organic EL element 30 having the structure as depicted in Fig. 3 and the organic EL element 40 having the structure as depicted in Fig. 4 are obtained, respectively.

Since the second electrode 20 is the metal electrode, a polarizing plate may be put on the second electrode 20 to address specular reflection of the metal electrode. Further, it is allowable to seal the periphery of each of the organic EL elements 30, 40 with a sealing material to prevent deterioration of each of the organic EL elements 30, 40 due to moisture and/or oxygen.

In the organic EL element according to this embodiment, when the base layer and the coating layer formed thereon are made of the sol-gel material, the adhesion property between the base layer and the coating layer is good, and the base layer and the coating layer have superior heat resistance, mechanical strength and chemical resistance. Therefore, in the organic EL manufacturing process, concave-convex pattern layers made of sol-gel material can satisfactorily withstand a film formation step performed under a high temperature atmosphere, $UV/O_3$ cleaning, brushing, a cleaning step using various cleaning liquids such as acid and alkali solvents, and a patterning step using a developer and an etching liquid.

Fig. 5 depicts a modified embodiment of the organic EL element according to the embodiment. An organic EL element 50 includes an optical functional layer 22 on the outer surface (surface on the side opposite to the surface on which the base layer 13 is formed) of the substrate 10 of the organic EL element 30 depicted in Fig. 3. Such optical functional layer 22 prevents the light passing through the substrate 10 from being totally reflected at the interface between the substrate 10 (including the optical functional layer 22) and air, thereby improving the light extraction efficiency. As the optical functional layer 22, it is possible to adopt, for example, a hemispherical lens or a lens having a corrugated structure. The optical functional layer 22 is not particularly limited, provided that the optical functional layer 22 is usable for extraction of light of the organic EL element. Any optical member having a structure, which is capable of extracting light to the outside of the element while controlling refraction of light, concentration of light, diffusion (scattering) of light, diffraction of light, reflection of light, and the like, can be used as the optical functional layer 22. As the optical functional layer 22, various lens members, a diffusion sheet or plate made of a transparent body into which diffusion material is blended, a diffusion sheet or plate which has a concave-convex structure on the surface thereof, a diffraction grating, a member having an antireflection function, or the like may be used. The various lens members include a convex lens such as the hemispherical lens, a concave lens, a prism lens, a cylindrical lens, a lenticular lens, a microlens formed of a concave-convex layer which can be formed by the method similar to a method for manufacturing a diffraction grating substrate as will be described later, and the like. Of the above examples, each of the lens members is preferably used because light can be extracted efficiently. Further, a plurality of lens members may be used as the optical functional layer 22. In this case, a so-called microlens (array) may be formed by arranging or arraying fine or minute lens members. A commercially available product may be used for the optical functional layer 22.

When the microlens formed of the concave-convex layer which can be formed by the method similar to the method for manufacturing the diffraction grating substrate is used as the optical functional layer 22, it is preferred that the Fourier-transformed image, which is obtained by performing a two-dimensional fast Fourier-transform processing on an concavity and convexity analysis image obtained by analyzing the concave-convex shape of the concave-convex layer of the microlens with an atomic force microscope, have a shape showing a circular or annular pattern substantially centered at an origin at which an absolute value of wavenumber is 0 $\mu m^{-1}$. As for the microlens formed of such a concave-convex layer, the concave-convex shape is isotropic as viewed from various cross-sectional directions. Thus, when the light, which has been allowed to enter from the side of one surface (surface in contact with the substrate), is extracted from the surface in which the concave-convex shape is formed, it is possible to sufficiently reduce the angle dependence of the extracted light (the angle dependence of luminance) and the change in chromaticity.

Further, when the microlens formed of the concave-convex layer is used as the optical functional layer 22, it is preferred that the Fourier-transformed image obtained from the concave-convex shape be present within a region where the absolute value of wavenumber is in a range of 1 $\mu m^{-1}$ or less. When such a Fourier-transformed image satisfies the above requirement, it is possible to sufficiently reduce the angle dependence of the extracted light and the change in chromaticity at a higher level. Further, it is preferred that the circular or annular pattern of the Fourier-transformed image be present within a region where the absolute value of wavenumber is in a range of 0.05 to 1 $\mu m^{-1}$, from the viewpoint of refracting or diffracting a light spectrum in a visible region (380 to 780 nm) efficiently. It is further preferred that the circular or annular pattern of the Fourier-transformed image be present within a region where the absolute value of wavenumber is in a range of 0.1 to 0.5 $\mu m^{-1}$. When the circular or annular pattern is not present in the region where the absolute value of wavenumber is in the above range, that is, when the number of bright spots, of the bright spots forming the Fourier-transformed image showing the circular or annular pattern, which are present in the above range, is less than 30%, refraction sufficient for use as a lens for extracting the light is less likely to be obtained. Further, it is further preferred that the pattern of the Fourier-transformed image be the annular pattern from the viewpoint of obtaining satisfactory effect for the light having wavelengths in the visible region (380 to 780 nm).

When the microlens formed of the concave-convex layer is used as the optical functional layer 22, the average pitch of concavities and convexities of the microlens is preferably in a range of 2 to 10 $\mu$m, and more preferably in a range of 2.5 to 5 $\mu$m. Further, the average value of depth distribution of concavities and convexities of the microlens is preferably in a range of 400 to 1000 nm, more preferably in a range of 600 to 1000 nm, and further preferably in range of 700 to 900 nm. The microlens formed of the concave-convex layer can be formed by adopting the method for manufacturing the substrate with the concave-convex structure, appropriately changing the conditions and the like for forming a master block, and appropriately adjusting characteristics (size and the like) of the concave-convex shape.

As the optical functional layer 22 for extracting the light to the outside, those having various sizes and shapes can be used depending on the use, the size, the structure, and the like of the organic EL element. From the viewpoint of preventing the reflection at the interface between air and the surface of the optical functional layer 22 (the structure for extracting light to the outside), it is preferred that the microlens formed of the hemispherical lens and the concave-convex layer, which can be formed by the method similar to the method for manufacturing the diffraction grating substrate as will be described later, be used. When the thickness of the organic EL element is considered to be unimportant (when there is no problem with a thick organic EL element), it is preferred that the hemispherical lens be used. When the thickness of the organic EL element is considered to be important (when a thinner organic EL element is preferred), it is preferred that the microlens formed of the concave-convex layer be used. When the microlens formed of the concave-convex layer, which can be formed by the method similar to the method for manufacturing the diffraction grating substrate, is used, the concave-convex shape is isotropic as viewed from various cross-sectional directions. Thus, when the light, which has been allowed to enter from the side of one surface (surface in contact with the substrate), is extracted from the surface in which the concave-convex shape is formed, it is possible to sufficiently reduce the angle dependence of the extracted light (the angle dependence of luminance) and the change in chromaticity. The optical functional layer 22 serves as a lens which mainly controls light refraction. The function of the optical functional layer 22 is not limited to that, and the optical functional layer 22 can be used as a layer which is aimed at giving various optical characteristics such as concentration of light, diffusion (scattering) of light, diffraction of light, and antireflection of light.

The material of the optical functional layer 22 is not particularly limited, an optical member made of any material can be used. It is possible to use, for example, transparent inorganic materials such as glass and transparent resin materials made of transparent polymers and the like, the transparent resin materials including polyester resin such as polyethylene terephthalate and the like, cellulose resin, acetate resin, polyethersulfone resin, polycarbonate resin, polyamide resin, polyimide resin, polyolefin resin, and acrylic resin. Further, in order to prevent the reflection at the interface between the organic EL element and the optical functional layer 22, it is preferred that the optical functional layer 22 be stacked on the substrate 10 via a pressure-sensitive adhesive layer and/or an adhesive layer to prevent air from being sandwiched between the organic EL element and the optical functional layer 22.

As for the optical functional layer 22, a protective layer may be stacked on the surface of the optical member (on the surface in which the concave-convex shape is formed, when the microlens formed of the concave-convex layer is used as the optical functional layer 22) from the viewpoint of improving wear resistance and scratch resistance of the surface thereof. It is possible to use a transparent film or a transparent inorganic deposited layer as the protective layer. The transparent film is not particularly limited, and any transparent film can be used. Examples of the transparent film include films made of transparent polymers such as polyester resin including polyethylene terephthalate and the like, cellulose resin, acetate resin, polyethersulfone resin, polycarbonate resin, polyamide resin, polyimide resin, polyolefin resin, and acrylic resin. Further, the transparent film may be used as follows. That is, the pressure-sensitive adhesive layer or the adhesive layer is formed on one surface of the transparent film, and the transparent film with the pressure-sensitive adhesive layer or the adhesive layer is put on the surface of the optical member. (Note that the transparent film may be put on the surface of the optical functional layer 22 so as to leave a space formed between the adjacent convex portions when the microlens formed of the concave-convex layer is used as the optical functional layer 22.) As the pressure-sensitive adhesive or the adhesive agent, it is possible to use, for example, acrylic adhesive, polyurethane adhesive, and polyester adhesive, ethylene-vinyl acetate copolymer, natural rubber adhesive, synthetic rubber pressure-sensitive adhesive such as polyisobutylene, butyl rubber, styrene-butylene-styrene copolymer, and styrene-isoprene-styrene block copolymer.

When the inorganic deposited layer is stacked as the protective layer, it is possible to appropriately use any known metallic material which can form a transparent inorganic layer by an evaporation method. Examples of the metallic material include oxide, nitride and sulfide of metal such as Sn, In, Te, Ti, Fe, Co, Zn, Ge, Pb, Cd, Bi, Se, Ga, and Rb. From the viewpoint of sufficiently preventing the deterioration caused by oxidation, it is preferred that $TiO_2$ be used as the metallic material. From the viewpoint of obtaining high luminance at a low cost, it is preferred that ZnS be used as the metallic material. The method for forming the inorganic deposited layer is not particularly limited, and it is possible to manufacture the inorganic deposited layer by using any physical vapor deposition equipment as appropriate.

Fig. 5 depicts the organic EL element 50 in which the optical functional layer 22 is formed on the outer surface (surface on the side opposite to the surface on which the base layer 13 is formed) of the substrate 10 of the organic EL element 30 depicted in Fig. 3. Alternatively, the optical functional layer 22 may be formed on the outer surface (surface on the side opposite to the surface on which the base layer 13 is formed) of the substrate 10 of the organic EL element 40 depicted in Fig. 4.

Examples

In the following description, the organic EL element using the substrate with the concave-convex structure according to the present invention will be specifically explained with examples. The present invention, however, is not limited to the following examples.

[Example 1]

In this example, a diffraction grating substrate (substrate provided with a concave-convex structure) is manufactured, and then an organic EL element is manufactured by use of the diffraction grating substrate.

<Manufacture of film mold>

At first, a film mold M-1 having a concave-convex surface was manufactured by the BCP solvent annealing method in order to manufacture the diffraction grating substrate. There was prepared a block copolymer produced by Polymer Source Inc., which was made of polystyrene (hereinafter referred to as "PS" in an abbreviated manner as appropriate) and polymethyl methacrylate (hereinafter referred to as "PMMA" in an abbreviated manner as appropriate) as described below.

Mn of PS segment = 590,000
Mn of PMMA segment = 570,000
Mn of block copolymer = 1,160,000
Volume ratio between PS segment and PMMA segment (PS:PMMA) = 54:46 Molecular weight distribution (Mw/Mn) = 1.25
Tg of PS segment = 107 degrees Celsius
Tg of PMMA segment = 134 degrees Celsius

The volume ratio between the PS segment and the PMMA segment (the PS segment: the PMMA segment) in the block copolymer was calculated on the assumption that the density of polystyrene was 1.05 $g/cm^3$ and the density of polymethyl methacrylate was 1.19 $g/cm^3$. The number average molecular weights (Mn) and the weight average molecular weights (Mw) of polymer segments or polymers were measured by using a gel permeation chromatography (Model No.: "GPC-8020" manufactured by TOSOH CORPORATION, in which TSKgel SuperH1000, SuperH2000, SuperH3000, and SuperH4000 were connected in series). The glass transition temperatures (Tg) of the polymer segments were measured by using a differential scanning calorimeter (manufactured by PERKIN-ELMER, INC. under the product name of "DSC7"), while the temperature was raised at a rate of temperature rise of 20°C/min over a temperature range of 0 to 200°C. The solubility parameters of polystyrene and polymethyl methacrylate were 9.0 and 9.3 respectively (see "Kagaku Binran Ouyou Hen" (Handbook of Chemistry, Applied Chemistry), 2nd edition).

Toluene was added to 210 mg of the block copolymer and 52.5 mg of Polyethylene Glycol 2050 (average Mn = 2050) manufactured by Sigma-Aldrich Co. LLC. as polyethylene oxide so that the total amount thereof was 15 g, followed by dissolving them. Accordingly, a solution of the block copolymer was prepared.

The solution of the block copolymer was filtered through a membrane filter having a pore diameter of 0.5 $\mu$m to obtain a block copolymer solution. A glass substrate was coated with a mixed solution containing 1 g of KBM-5103 manufactured by SHIN-ETSU SILICONE (SHIN-ETSU CHEMICAL, CO., LTD.), 1 g of ion-exchanged water, 0.1 ml of acetic acid, and 19 g of isopropyl alcohol, by means of the spin coating (which was performed for 10 seconds with rotation speed of 500 rpm, and then performed continuously for 45 seconds with rotation speed of 800 rpm). The treatment was performed for 15 minutes at 130°, and thus a silane coupling treated glass was obtained. The silane coupling treated glass as the base member was coated with the obtained block copolymer solution by means of the spin coating to provide a thickness in a range of 100 to 120 nm. The spin coating was performed for 10 seconds at a rotation speed of 200 rpm and then was performed for 30 seconds at a rotation speed of 300 rpm.

Then, the base member on which the thin film was formed was subjected to a solvent annealing process by being stationarily placed in a desiccator filled with chloroform vapor in advance at room temperature for 24 hours. Inside the desiccator (volume: 5 L), a screw-type container charged with 100 g of chloroform was placed, and the atmosphere inside the desiccator was filled with chloroform at the saturated vapor pressure. Concavities and convexities were observed on the surface of the thin film after the solvent annealing process, and it was found that the block copolymer forming the thin film underwent the micro phase separation. The cross section of the thin film was observed by using a transmission electron microscope (TEM) (H-7100FA manufactured by HITACHI, LTD.). As a result, the circular cross section of the PS portion was aligned in two tiers (stages or rows) in a direction perpendicular to the surface of the substrate (height direction) while the circular cross sections of the PS portion were separated from each other in a direction parallel to the surface of the substrate. When considering together with an analysis image obtained by using an atomic force microscope, it was revealed that the PS portion was subjected to the phase separation to form a horizontal cylinder structure from the PMMA portion. A state was given, in which the PS portion existing as the core (island) was surrounded by the PMMA portion (sea).

About 20 nm of a thin nickel layer was formed as a current seed layer by performing the sputtering on the surface of the thin film processed to have the wave-like shape by means of the solvent annealing process as described above. Subsequently, the base member equipped with the thin film was immersed in a nickel sulfamate bath and subjected to an electroforming process (maximum current density: 0.05 A/cm$^2$) at a temperature of 50°C so as to precipitate nickel until the thickness became 250 $\mu$m. The base member equipped with the thin film was mechanically peeled off or released from the nickel electroforming body obtained as described above. Subsequently, the nickel electroforming body was immersed in a tetrahydrofuran solvent for 2 hours, and then the nickel electroforming body was coated with an acrylic-based UV curable resin, followed by being cured and peeled off. This process was repeated three times, and thus polymer component(s) adhered to a part of the surface of the electroforming body was (were) removed. After that, the nickel electroforming body was immersed in Chemisol 2303 manufactured by THE JAPAN CEE-BEE CHEMICAL CO., LTD., and was cleaned or washed while being stirred or agitated for 2 hours at 50°C. Thereafter, the UV ozone treatment was applied to the nickel electroforming body for 10 minutes.

Subsequently, the nickel electroforming body was immersed in HD-2101TH manufactured by DAIKIN CHEMICALS SALES, CO., LTD. for about 1 minute and was dried, and then stationarily placed overnight. The next day, the nickel electro forming body was immersed in HDTH manufactured by DAIKIN CHEMICALS SALES, CO., LTD. and was subjected to an ultrasonic cleaning (washing) process for about 1 minute. In such a manner, a nickel mold for which a mold-release treatment had been performed was obtained.

Subsequently, a PET substrate (COSMOSHINE A-4100 manufactured by TOYOBO CO., LTD.) was coated with a fluorine-based UV curable resin. The fluorine-based UV curable resin was cured by irradiation with ultraviolet light at 600 mJ/cm$^2$ while the nickel mold was pressed thereagainst. After curing of the resin, the nickel mold was exfoliated or peeled off from the cured resin. Accordingly, the film mold M-1, which was composed of the PET substrate with the resin film to which the surface profile (surface shape) of the nickel mold was transferred, was obtained.

<Formation of base layer>

3.74 g of tetraethoxysilane (TEOS) and 0.89 g of methyltriethoxysilane (MTES) were added dropwise to a mixture solution of 24.3 g of ethanol, 2.15 g of water, and 0.0098 g of concentrated hydrochloric acid, followed by being stirred or agitated for 2 hours at a temperature of 23°C and a humidity of 45% to obtain a SiO$_2$ so-gel material solution as the base material. The base material was applied onto an alkali-free glass substrate (glass plate) of 10 x 10 x 0.07 cm (OA10GF produced by Nippon Electric Glass Co., Ltd.) by means of the bar coating, thereby forming a coating film (base material layer). Doctor Blade (manufactured by YOSHIMITSU SEIKI CO., LTD.) was used as a bar coater. The doctor blade was designed such that the thickness of the coating film was 5 $\mu$m. However, the doctor blade was adjusted such that the thickness of the coating film was 40 $\mu$m by sticking an imide tape having a thickness of 35 $\mu$m to the doctor blade. After the elapse of 60 seconds from the application of the sol-gel material solution (base material) onto the glass plate, the film mold M-1 manufactured as described above was pressed against the coating film (base material layer) on the glass plate by use of the pressing roll heated to 80 degrees Celsius while the pressing roll was moved and rotated. After the completion of pressing against the coating film, the film mold M-1 was released from the coating film on the glass plate and the coating film on the glass plate was subjected to the main baking by being heated for 60 minutes in an oven of 300 degrees Celsius. Accordingly, the base layer in which the concave-convex pattern of the film mold M-1 was transferred was formed on the glass substrate. As the pressing roll, it was used a roll which included a heater therein and had the outer circumference covered with heat-resistant silicon of a thickness of 4 mm, the roll having a diameter ($\varphi$) of 50 mm and a length of 350 mm in an axial direction of the shaft.

An analysis image of the shape of the concavities and convexities on the surface of the concave-convex pattern of the base layer was obtained by use of an atomic force microscope (a scanning probe microscope equipped with an environment control unit "Nanonavi II Station/E-sweep" manufactured by Hitachi High-Tech Science Corporation). Analysis conditions of the atomic force microscope were as follows.

Measurement mode: dynamic force mode
Cantilever: SI-DF40 (material: Si, lever width: 40 $\mu$m, diameter of tip of chip: 10 nm) Measurement atmosphere: in air
Measurement temperature: 25 degrees Celsius

<Average depth of concavities and convexities>

A concavity and convexity analysis image was obtained as described above by performing a measurement in a randomly selected measuring region of 3 μm square (length: 3 μm, width: 3 μm) in the base layer. Distances between randomly selected concave portions and convex portions in the depth direction were measured at 100 points or more in the concavity and convexity analysis image, and the average of the distances was calculated as the average depth of the concavities and convexities. The average depth of the concave-convex pattern of the base layer obtained by the analysis image in this example was 58 nm.

<Fourier-transformed image of concavity and convexity analysis image>

A concavity and convexity analysis image was obtained as described above by performing a measurement in a randomly selected measuring region of 3 μm square (length: 3 μm, width: 3 μm) in the base layer. The obtained concavity and convexity analysis image was subjected to the flat processing including primary inclination correction, and then subjected to the two-dimensional fast Fourier transform processing. Thus, a Fourier-transformed image was obtained. It was confirmed that the Fourier-transformed image showed a circular pattern substantially centered at an origin at which an absolute value of wavenumber was 0 μm$^{-1}$, and that the circular pattern was present within a region where the absolute value of wavenumber was in a range of 10 μm$^{-1}$ or less.
The circular pattern of the Fourier-transformed image is a pattern observed due to gathering of bright spots in the Fourier-transformed image. The term "circular" herein means that the pattern of the gathering of the bright spots looks like a substantially circular shape, and is a concept further including a case where a part of a contour looks like a convex shape or a concave shape. The pattern of the gathering of the bright spots may look like a substantially annular shape, and this case is expressed as the term "annular". It is noted that the term "annular" is a concept further including a case where a shape of an outer circle or inner circle of the ring looks like a substantially circular shape and a case where a part of the contour of the outer circle or the inner circle of the ring looks like a convex shape or a concave shape. Further, the phrase "the circular or annular pattern is present within a region where the absolute value of wavenumber is 10 μm$^{-1}$ or less (more preferably in a range of 0.667 to 10 μm$^{-1}$, further preferably in a range of 0.833 to 5 μm$^{-1}$)" means that 30% or more (more preferably 50% or more, further more preferably 80% or more, and particularly preferably 90% or more) of bright spots forming the Fourier-transformed image are present within a region where the absolute value of wavenumber is 10 μm$^{-1}$ or less (more preferably in a range of 0.667 to 10 μm$^{-1}$, and further preferably in a range of 0.833 to 5 μm$^{-1}$). Regarding the relationship between the pattern of the concave-convex structure and the Fourier-transformed image, the followings have been revealed. That is, when the concave-convex structure itself has neither the pitch distribution nor the directivity, the Fourier-transformed image appears to have a random pattern (no pattern). When the concave-convex structure is entirely isotropic in an XY direction and has the pitch distribution, a circular or annular Fourier-transformed image appears. When the concave-convex structure has a single pitch, the annular shape appeared in the Fourier-transformed image tends to be sharp.
The two-dimensional fast Fourier transform processing on the concavity and convexity analysis image can be easily performed by electronic image processing by use of a computer equipped with software for the two-dimensional fast Fourier transform processing.

<Average pitch of concavities and convexities>

A concavity and convexity analysis image was obtained as described above by performing a measurement in a randomly selected measuring region of 3 μm square (length: 3 μm, width: 3 μm) in the base layer. Distances between randomly selected adjacent convex portions or between randomly selected adjacent concave portions were measured at 100 points or more in the concavity and convexity analysis image, and the average of the distances was calculated as the average pitch of the concavities and convexities. The average pitch of the concave-convex pattern of the base layer calculated using the analysis image obtained in this example was 322 nm.

<Average value of depth distribution of concavities and convexities>

A concavity and convexity analysis image was obtained by performing a measurement in a randomly selected measuring region of 3 μm square (length: 3 μm, width: 3 μm) in the base layer. Here, the data of each of the depth of concavities and convexities was determined at 16,384 (vertical: 128 points x horizontal: 128 points) or more measuring points in the measuring region on the nanometer scale. By using E-sweep in this example, a measurement at 65,536 points (vertical: 256 points x horizontal: 256 points) (a measurement with a resolution of 256 pixels x 256 pixels) was conducted in a measuring region of 3 μm square. With respect to the depth of concavities and convexities (unit: nm) measured in such a manner, at first, a measurement point "P" was determined, among all the measurement points, which was the highest from the surface of the substrate. Then, a plane which included the measurement point P and which was parallel to the surface of the substrate was determined as a reference plane (horizontal plane), and a depth value from the reference plane (difference obtained by subtracting, from the value of height from the substrate at the measurement point P, the height from the substrate at each of the measurement points) was obtained as the data of depth of concavities and convexities. Note that such a depth data of the concavities and convexities was able to be obtained, for example, by performing automatic calculation with software in the E-sweep, and the value obtained by the automatic calculation in such a manner was able to be utilized as the data of depth of concavities and convexities. After obtaining the data of depth of concavity and convexity at each of the measurement points in this manner, the average value (m) of the depth distribution of the concavities and convexities was able to be determined by calculation according to the following formula (I):

[Formula I]

$$m = \frac{1}{N} \sum_{i=1}^{N} x_i \qquad (\mathrm{I})$$

The average value (m) of depth distribution of concavities and convexities of the base layer obtained in this example was 36.1 nm.

<Standard deviation of depth of concavities and convexities>

Similar to the method for measuring the average value (m) of the depth distribution, the data of depth of the concavities and convexities were obtained by performing a measurement at 16,384 or more measuring points (vertical: 128 points x horizontal: 128 points) in a measuring region of 3 $\mu$m square of the base layer. In this example, a measurement was performed adopting 65,536 measuring points (vertical: 256 points x horizontal: 256 points). Thereafter, the average value (m) of the depth distribution of the concavities and convexities and the standard deviation ($\sigma$) of depth of the concavities and convexities were calculated on the basis of the data of depth of concavities and convexities of the measuring points. Note that, the average value (m) was able to be determined by calculation according to the formula (I) as described above. Meanwhile, the standard deviation ($\sigma$) of depth of the concavities and convexities was able to be determined by calculation according to the following formula (II):

[Formula II]

$$\sigma = \sqrt{\frac{1}{N} \sum_{i=1}^{N} (x_i - m)^2} \qquad (\mathrm{II})$$

In the formula (II), "N" represents the total number of measuring points (the number of all the pixels), "$x_i$" represents the data of depth of the concavities and convexities at the i-th measuring point, and "m" represents the average value of the depth distribution of the concavities and convexities. The standard deviation ($\sigma$1) of depth of concavities and convexities in the base layer was 21.8 nm.

<Formation of coating layer>

The glass substrate obtained as described above and having the base layer formed thereon, the base layer having the concave-convex pattern transferred thereon, was cut to have a size of 12 mm x 20 mm, and foreign substances, such as organic matter, adhering to the glass substrate was removed by performing ultrasonic cleaning by use of IPA which was an organic solvent. Subsequently, the glass substrate was subjected to the UV ozone process for 3 minutes in a state of being separated from the light source by 3 cm. Then, the base material was diluted by using ethanol and butanol as a solvent such that the base material was diluted about 10 times with the solvent in the volume ratio. The ethanol and butanol were used in the ratio by volume of 9 to 1 (ethanol:butanol= 9:1). This diluted solution was filtrated or filtered through a filter of 0.50 $\mu$m$\varphi$ and the filtered solution was used as the coating material. This coating material was applied on the concave-convex pattern of the base layer formed on the glass substrate by spin coating, and thus the coating layer was formed. The thickness d of the coating layer was 6.3 nm, and was 31% of the standard deviation $\sigma$1 of depth of concavities and convexities in the base layer. The glass substrate was cured by being baked for 1 hour in an oven of 300 degrees Celsius. Note that, it was difficult to measure the thickness of the coating layer directly, because the surface of the coating layer had the concave-convex shape by reflecting the concave-convex pattern of the base layer and the coating layer and the base layer were made of the same material. Thus, the thickness of the coating layer was measured as follows. Namely, the coating material was applied onto an alkali-free glass substrate of 12 x 20 x 0.07 cm (OA10GF produced by Nippon Electric Glass Co., Ltd.), of which surface was flat, by means of spin coating. The spin coating was performed under the same conditions (rotation speed, rotation time) as those of the spin coating which was performed to apply the coating material on the base layer. Then, the substrate after the spin coating was baked for 1 hour in an oven of 300 degrees Celsius, and the film thickness after the baking was measured by an automatic thin film measurement tool "Auto SE" produced by HORIBA, Ltd. The film thickness obtained described above was regarded as "thickness of the coating layer".

The standard deviation of depth of concavities and convexities of the coating layer obtained as described above was determined by use of the above formula (II) based on the analysis image by the atomic force microscope, in the same manner as the case of the concave-convex pattern layer of the base layer. The standard deviation ($\sigma$2) of depth of concavities and convexities of the coating layer was 20.1 nm. Then, the shape maintenance ratio (W = σ2/σ1) was obtained by using the value of the standard deviation (σ2) of depth of concavities and convexities of the coating layer and the value of the standard deviation (σ1) of depth of concavities and convexities of the base layer obtained in advance. The shape maintenance ratio was 92%.

<Manufacture of organic EL element>

Subsequently, an ITO film having a thickness of 120 nm was formed on the diffraction grating substrate obtained as described above by sputtering. Then, as the organic layer, a hole transporting layer (4,4',4" tris(9-carbazole)triphenylamine, thickness: 35 nm), a light emitting layer (tris(2-phenylpyridinato)iridium(III) complex-doped 4,4',4"tris(9-carbazole)triphenylamine, thickness: 15 nm; tris(2-phenylpyridinato)iridium(III) complex-doped 1,3,5-tris(N-phenylbenzimidazole-2-yl)benzene, thickness: 15 nm), and an electron transporting layer (1,3,5-tris(N-phenylbenzimidazole-2-yl)benzene, thickness: 65 nm), were each stacked by a vapor deposition method. Further, a lithium fluoride layer (thickness: 1.5 nm) and a metal electrode (aluminum, thickness: 50 nm) were formed by the vapor deposition method. Accordingly, as depicted in Fig. 3, there was obtained the organic EL element in which the concave-convex structure layer formed of the base layer 13 and the coating layer 14, the transparent electrode as the first electrode 16, the organic layer 18, and the metal electrode as the second electrode 20 were formed on the substrate 10 in that order.

The table of Fig. 6 shows the standard deviation (σ1) of depth of concavities and convexities in the base layer, the thickness (d) of the coating layer, the ratio (d/σ1) of the thickness of the coating layer to the standard deviation of depth of concavities and convexities in the base layer, the standard deviation (σ2) of depth of concavities and convexities in the coating layer, and the shape maintenance ratio (σ2/σ1), of the organic EL element obtained in this example.

[Examples 2 to 4]

In each of Examples 2 to 4, an organic EL element was manufactured under the same method and conditions as those of Example 1, except that the thickness d of the coating layer was changed to 13.8 nm in Example 2, 22.4 nm in Example 3, and 26.6 nm in Example 4. The ratio (d/σ1) of the thickness d of the coating layer to the standard deviation σ1 of depth of concavities and convexities in the base layer was 69% in Example 2, 111% in Example 3, and 132% in Example 4. The standard deviation of depth of concavities and convexities in the coating layer was 16.3 nm in Example 2, 12.7 nm in Example 3, and 11.7 nm in Example 4. The shape maintenance ratio was obtained by using the value of the standard deviation of depth of concavities and convexities of the coating layer and the value of the standard deviation of depth of concavities and convexities of the base layer obtained in advance. The shape maintenance ratio was 75% in Example 2, 58% in Example 3, and 54% in Example 4. The table of Fig. 6 shows the standard deviation (σ1) of depth of concavities and convexities in the base layer, the thickness (d) of the coating layer, the ratio (d/σ1) of the thickness of the coating layer to the standard deviation of depth of concavities and convexities in the base layer, the standard deviation (σ2) of depth of concavities and convexities in the coating layer, and the shape maintenance ratio (σ2/σ1), of the organic EL element obtained in each of Examples 2 to 4.

[Example 5]

<Manufacture of film mold>

At first, a film mold M-2 having a concave-convex surface was manufactured by the BCP solvent annealing method in order to manufacture a diffraction grating substrate. The film mold M-2 was manufactured under the same method and conditions as those of the film mold M-1 manufactured in Example 1 except for the following points. Namely, in Example 5, there was prepared a block copolymer produced by Polymer Source Inc., which was made of polystyrene and polymethyl methacrylate as described below. Toluene was added to 230 mg of the block copolymer and 57.5 mg of Polyethylene Glycol 2050 manufactured by Sigma-Aldrich Co. LLC. as polyethylene oxide so that the total amount thereof was 15 g, followed by dissolving them. The solution of the block copolymer thus obtained was applied on a substrate to have a thickness of 140 to 160 nm.

Mn of PS segment = 680,000
Mn of PMMA segment = 580,000
Mn of block copolymer = 1,260,000
Volume ratio between PS segment and PMMA segment (PS:PMMA) = 57:43 Molecular weight distribution (Mw/Mn) = 1.28
Tg of PS segment = 107 degrees Celsius
Tg of PMMA segment = 134 degrees Celsius

<Formation of base layer>

The base layer was formed in the same manner as Example 1 except for the following points. Namely, the film mold M-2 was used instead of the film mold M-1 and a concavity and convexity analysis image was obtained by measuring a measurement region of 10 μm square (vertical: 10 μm, horizontal: 10 μm) instead of obtaining a concavity and convexity analysis image by measuring a measurement region of 3 μm square (vertical: 3 μm, horizontal: 3 μm) in order to calculate the average depth of the concave-convex pattern, the Fourier-transformed image of the concavity and convexity analysis image, the average pitch of the concave-convex pattern, the average value (m) of depth distribution of concavities and convexities, and the standard deviation

($\sigma$1) of depth of concavities and convexities. The average depth of the concave-convex pattern was 112 nm. It was confirmed that the Fourier-transformed image of the concavity and convexity analysis image showed a circular pattern substantially centered at an origin at which an absolute value of wavenumber was 0 $\mu$m$^{-1}$, and that the circular pattern was present within a region where the absolute value of wavenumber was in a range of 10 $\mu$m$^{-1}$ or less. The average pitch of the concave-convex pattern was 586 nm, the average value (m) of depth distribution of concavities and convexities was 86.3 nm, and the standard deviation ($\sigma$1) of depth of concavities and convexities was 41.8 nm.

<Formation of coating layer>

The diffraction grating substrate, in which the coating layer was formed on the base layer having the concave-convex pattern, was obtained by forming the coating layer under the same method and conditions as those of Example 1 except for the following points. Namely, the thickness d of the coating layer was changed to 11.2 nm and a concavity and convexity analysis image was obtained by measuring a measurement region of 10 $\mu$m square (vertical: 10 $\mu$m, horizontal: 10 $\mu$m) instead of obtaining a concavity and convexity analysis image by measuring a measurement region of 3 $\mu$m square (vertical: 3 $\mu$m, horizontal: 3 $\mu$m) in order to calculate the standard deviation ($\sigma$2) of depth of concavities and convexities of the coating layer. The thickness d of the coating layer was 27% of the standard deviation ($\sigma$1) of depth of concavities and convexities in the base layer. The standard deviation of depth of concavities and convexities of the coating layer was 38.9 nm. The shape maintenance ratio, which was obtained by using the value of the standard deviation of depth of concavities and convexities of the coating layer and the value of the standard deviation of depth of concavities and convexities of the base layer obtained in advance, was 93%.

<Manufacture of organic EL element>

An organic EL element was manufactured in the same manner as Example 1 by using the diffraction grating substrate with the concave-convex pattern layer formed of the base layer and the coating layer obtained above. The table of Fig. 6 shows the standard deviation ($\sigma$1) of depth of concavities and convexities in the base layer, the thickness (d) of the coating layer, the ratio (d/$\sigma$1) of the thickness of the coating layer to the standard deviation of the thickness of the coating layer to the standard deviation of depth of concavities and convexities in the base layer, the standard deviation ($\sigma$2) of depth of concavities and convexities in the coating layer, and the shape maintenance ratio ($\sigma$2/$\sigma$1), of the organic EL element obtained in Example 5.

[Examples 6 to 8]

In each of Examples 6 to 8, an organic EL element was manufactured under the same method and conditions as those of Example 5, except that the thickness d of the coating layer was changed to 19.5 nm in Example 6, 39.0 nm in Example 7, and 58.7 nm in Example 8. The ratio (d/$\sigma$1) of the thickness d of the coating layer to the standard deviation $\sigma$1 of depth of concavities and convexities in the base layer was 47% in Example 6, 93% in Example 7, and 140% in Example 8. The standard deviation of depth of concavities and convexities in the coating layer was 36.4 nm in Example 6, 30.6 nm in Example 7, and 21.6 nm in Example 8. The shape maintenance ratio, which was obtained by using the value of the standard deviation of depth of concavities and convexities of the coating layer and the value of the standard deviation of depth of concavities and convexities of the base layer obtained in advance, was 87% in Example 6, 73% in Example 7, and 52% in Example 8. The table of Fig. 6 shows the standard deviation ($\sigma$1) of depth of concavities and convexities in the base layer, the thickness (d) of the coating layer, the ratio (d/$\sigma$1) of the thickness of the coating layer to the standard deviation of depth of concavities and convexities in the base layer, the standard deviation ($\sigma$2) of depth of concavities and convexities in the coating layer, and the shape maintenance ratio ($\sigma$2/$\sigma$1), of the organic EL element obtained in each of Examples 6 to 8.

[Example 9]

An organic EL element was manufactured under the same method and conditions as those of Example 5 except for the following points. Namely, a diluted solution, in which a fluorine-based UV curable resin was diluted 100 times with isobutyl acetate in the volume ratio, was used as the coating material, instead of using the diluted solution of the base material; and this diluted solution was applied on the base layer by spin coating and then the UV curable resin was cured by being irradiated with ultraviolet rays at 600 mJ/cm$^2$ in nitrogen atmosphere to form the coating layer. The thickness d of the coating layer was 33.8 nm and was 78% of the standard deviation $\sigma$1 of depth of concavities and convexities in the base layer. The standard deviation of depth of concavities and convexities in the coating layer was 31.2 nm. The shape maintenance ratio, which was obtained by using the value of the standard deviation of depth of concavities and convexities of the coating layer and the value of the standard deviation of depth of concavities and convexities of the base layer obtained in advance, was 72%. The table of Fig. 6 shows the standard deviation ($\sigma$1) of depth of concavities and convexities in the base layer, the thickness d of the coating layer, the ratio (d/$\sigma$1) of the thickness of the coating layer to the standard deviation of depth of concavities and convexities in the base layer, the standard deviation ($\sigma$2) of depth of concavities and convexities in the coating layer, and the shape maintenance ratio ($\sigma2/\sigma1$), of the organic EL element obtained in Example 9.

[Example 10]

An organic EL element was manufactured under the same method and conditions as those of Example 5 except for the following points. Namely, a silane coupling agent (KBM-5103 produced by Shin-Etsu Chemical Co., Ltd.) was used as the coating material, instead of using the diluted solution of the base material; and the silane coupling agent was applied on the base layer by spin coating and then the silane coupling agent was dried for 15 minutes in a clean air oven heated to 130 degrees Celsius to form the coating layer. The thickness d of the coating layer was 10.7 nm and was 26% of the standard deviation $\sigma1$ of depth of concavities and convexities in the base layer. The standard deviation of depth of concavities and convexities in the coating layer was 37.5 nm. The shape maintenance ratio, which was obtained by using the value of the standard deviation of depth of concavities and convexities of the coating layer and the value of the standard deviation of depth of concavities and convexities of the base layer obtained in advance, was 90%. The table of Fig. 6 shows the standard deviation ($\sigma1$) of depth of concavities and convexities in the base layer, the thickness d of the coating layer, the ratio (d/$\sigma1$) of the thickness of the coating layer to the standard deviation of depth of concavities and convexities in the base layer, the standard deviation ($\sigma2$) of depth of concavities and convexities in the coating layer, and the shape maintenance ratio ($\sigma2/\sigma1$), of the organic EL element obtained in Example 10.

[Example 11]

An organic EL element was manufactured under the same method and conditions as those of Example 5 except for the following points. Namely, a solution, in which a fluorine-based UV curable resin was diluted 100 times with isobutyl acetate in the volume ratio and further an ultraviolet absorber (TINUVIN928, produced by BASF Japan Ltd.), of which weight was 10% of the weight of the fluorine-based UV curable resin before dilution, was added to the diluted solution, was used as the coating material, instead of using the diluted solution of the base material; and the diluted solution thus obtained was applied on the base layer by spin coating and then the UV curable resin was cured by being irradiated with ultraviolet rays at 600 mJ/cm$^2$ in nitrogen atmosphere to form the coating layer. The thickness d of the coating layer was 32.5 nm and was 75% of the standard deviation $\sigma1$ of depth of concavities and convexities in the base layer. The standard deviation of depth of concavities and convexities in the coating layer was 31.7 nm. The shape maintenance ratio, which was obtained by using the value of the standard deviation of depth of concavities and convexities of the coating layer and the value of the standard deviation of depth of concavities and convexities of the base layer obtained in advance, was 73%. The table of Fig. 6 shows the standard deviation ($\sigma1$) of depth of concavities and convexities in the base layer, the thickness d of the coating layer, the ratio (d/$\sigma1$) of the thickness of the coating layer to the standard deviation of depth of concavities and convexities in the base layer, the standard deviation ($\sigma2$) of depth of concavities and convexities in the coating layer, and the shape maintenance ratio ($\sigma2/\sigma1$), of the organic EL element obtained in Example 11.

[Example 12]

<Manufacture of film mold>

At first, a film mold M-3 having a concave-convex surface was manufactured by the BCP solvent annealing method in order to manufacture a diffraction grating substrate. The film mold M-3 was manufactured under the same method and conditions as those of the film mold M-1 manufactured in Example 1 except for the following points. Namely, in Example 12, there was prepared a block copolymer produced by Polymer Source Inc., which was made of polystyrene and polymethyl methacrylate as described below. Toluene was added to 240 mg of the block copolymer and 60.0 mg of Polyethylene Glycol 2050 manufactured by Sigma-Aldrich Co. LLC. as polyethylene oxide so that the total amount thereof was 15 g, followed by dissolving them. The solution of the block copolymer thus obtained was applied on a substrate to have a thickness of 170 to 190 nm.

> Mn of PS segment = 900,000
> Mn of PMMA segment = 800,000
> Mn of block copolymer = 1,700,000
> Volume ratio between PS segment and PMMA segment (PS:PMMA) = 55:45 Molecular weight distribution (Mw/Mn) = 1.26
> Tg of PS segment = 107 degrees Celsius
> Tg of PMMA segment = 134 degrees Celsius

<Formation of base layer>

The base layer was formed in the same manner as Example 1 except for the following points. Namely, the film mold M-3 was used instead of the film mold M-1 and a concavity and convexity analysis image was obtained by measuring a measurement region of 10 $\mu$m square (vertical: 10 $\mu$m, horizontal: 10 $\mu$m) instead of obtaining a concavity and convexity analysis image by measuring a measurement region of 3 $\mu$m square (vertical: 3 $\mu$m, horizontal: 3 $\mu$m) in order to calculate the average depth of the concave-convex pattern, the Fourier-transformed image of the concavity and convexity analysis image, the average pitch of the concave-convex pattern, the average value (m) of depth distribution of concavities and convexities, and the standard deviation (σ1) of depth of concavities and convexities. The average depth of the concave-convex pattern was 133 nm. It was confirmed that the Fourier-transformed image of the concavity and convexity analysis image showed a circular pattern substantially centered at an origin at which an absolute value of wavenumber was 0 $\mu$m$^{-1}$, and that the circular pattern was present within a region where the absolute value of wavenumber was in a range of 10 $\mu$m$^{-1}$ or less. The average pitch of the concave-convex pattern was 906 nm, the average value (m) of depth distribution of concavities and convexities was 83.6 nm, and the standard deviation (σ1) of depth of concavities and convexities was 43.5 nm.

<Formation of coating layer>

The diffraction grating substrate, in which the coating layer was formed on the base layer having the concave-convex pattern, was obtained by forming the coating layer under the same method and conditions as those of Example 1 except for the following points. Namely, the thickness d of the coating layer was changed to 11.8 nm and a concavity and convexity analysis image was obtained by measuring a measurement region of 10 $\mu$m square (vertical: 10 $\mu$m, horizontal: 10 $\mu$m) instead of obtaining a concavity and convexity analysis image by measuring a measurement region of 3 $\mu$m square (vertical: 3 $\mu$m, horizontal: 3 $\mu$m) in order to calculate the standard deviation (σ2) of depth of concavities and convexities of the coating layer. The thickness d of the coating layer was 27% of the standard deviation σ1 of depth of concavities and convexities in the base layer. The standard deviation of depth of concavities and convexities of the coating layer was 39.4 nm. The shape maintenance ratio, which was obtained by using the value of the standard deviation of depth of concavities and convexities of the coating layer and the value of the standard deviation of depth of concavities and convexities of the base layer obtained in advance, was 91 %.

<Manufacture of organic EL element>

An organic EL element was manufactured in the same manner as Example 1 by using the diffraction grating substrate obtained as described above. The table of Fig. 6 shows the standard deviation (σ1) of depth of concavities and convexities in the base layer, the thickness d of the coating layer, the ratio (d/σ1) of the thickness of the coating layer to the standard deviation of depth of concavities and convexities in the base layer, the standard deviation (σ2) of depth of concavities and convexities in the coating layer, and the shape maintenance ratio (σ2/σ1), of the organic EL element obtained in Example 12.

[Examples 13 to 16]

In each of Examples 13 to 16, an organic EL element was manufactured under the same method and conditions as those of Example 12, except that the thickness d of the coating layer was changed to 21.1 nm in Example 13, 40.1 nm in Example 14, 45.8 nm in Example 15, and 56.7 nm in Example 16. The ratio (d/σ1) of the thickness d of the coating layer to the standard deviation σ1 of depth of concavities and convexities in the base layer was 49% in Example 13, 92% in Example 14, 105% in Example 15, and 130% in Example 16. The standard deviation of depth of concavities and convexities in the coating layer was 36.4 nm in Example 13, 32.1 nm in Example 14, 29.8 nm in Example 15, and 23.7 nm in Example 16. The shape maintenance ratio, which was obtained by using the value of the standard deviation of depth of concavities and convexities of the coating layer and the value of the standard deviation of depth of concavities and convexities of the base layer obtained in advance, was 84% in Example 13, 74% in Example 14, 69% in Example 15, and 54% in Example 16. The table of Fig. 6 shows the standard deviation (σ1) of depth of concavities and convexities in the base layer, the thickness d of the coating layer, the ratio (d/σ1) of the thickness of the coating layer to the standard deviation of depth of concavities and convexities in the base layer, the standard deviation (σ2) of depth of concavities and convexities in the coating layer, and the shape maintenance ratio (σ2/σ1), of the organic EL element obtained in each of Examples 13 to 16.

[Comparative Example 1]

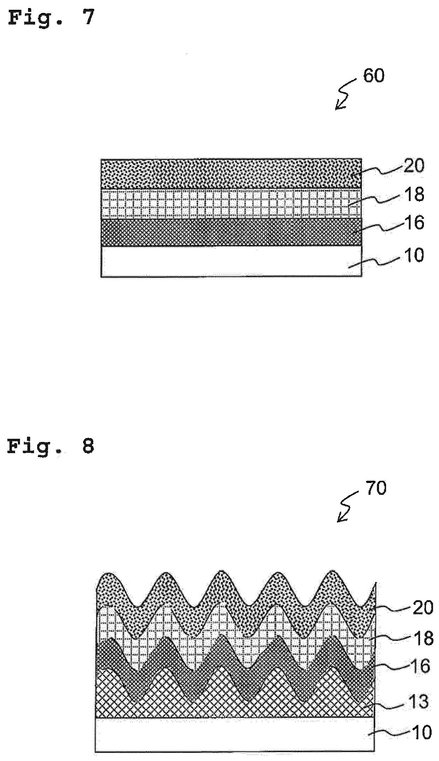

An organic EL element was manufactured in the same manner as Example 1 except that no base layer and no coating layer were formed on a glass substrate. Namely, the organic EL element was manufactured by forming the transparent electrode as the first electrode, the organic layer, and the metal electrode as the second electrode on the glass substrate under the same method and conditions as those as Example 1. Fig. 7 schematically depicts a cross-section structure of the organic EL element obtained in Comparative Example 1. As depicted in Fig. 7, in an organic EL element 60 of Comparative Example 1, the first electrode 16, the organic layer 18, and the second electrode 20 were stacked on the substrate 10 in that order.

[Comparative Example 2]

An organic EL element was manufactured under the same method and conditions as those of Example 1 except that no coating layer was formed. Fig. 8 schematically depicts a cross-section structure of the organic EL element obtained in Comparative Example 2. As depicted in Fig. 8, in an organic EL element 70 of Comparative Example 2, the base layer 13 having the concave-convex pattern, the first electrode 16, the organic layer 18, and the second electrode 20 were stacked on the substrate 10 in that order.

[Comparative Example 3]

An organic EL element was manufactured under the same method and conditions as those of Example 1, except that the thickness d of the coating layer was changed to 3.2 nm. The thickness d of the coating layer was 15% of the standard deviation $\sigma 1$ of depth of concavities and convexities in the base layer. The standard deviation of depth of concavities and convexities in the coating layer was 21.4 nm. The shape maintenance ratio, which was obtained by using the value of the standard deviation of depth of concavities and convexities of the coating layer and the value of the standard deviation of depth of concavities and convexities of the base layer obtained in advance, was 98%. The table of Fig. 6 shows the standard deviation ($\sigma 1$) of depth of concavities and convexities in the base layer, the thickness d of the coating layer, the ratio (d/$\sigma 1$) of the thickness of the coating layer to the standard deviation of depth of concavities and convexities in the base layer, the standard deviation ($\sigma 2$) of depth of concavities and convexities in the coating layer, and the shape maintenance ratio ($\sigma 2/\sigma 1$), of the organic EL element obtained in Comparative Example 3.

[Comparative Example 4]

An organic EL element was manufactured under the same method and conditions as those of Example 1, except that the thickness d of the coating layer was changed to 38.7 nm. The thickness d of the coating layer was 193% of the standard deviation $\sigma 1$ of depth of concavities and convexities in the base layer. The standard deviation of depth of concavities and convexities in the coating layer was 7.8 nm. The shape maintenance ratio, which was obtained by using the value of the standard deviation of depth of concavities and convexities of the coating layer and the value of the standard deviation of depth of concavities and convexities of the base layer obtained in advance, was 36%. The table of Fig. 6 shows the standard deviation ($\sigma 1$) of depth of concavities and convexities in the base layer, the thickness d of the coating layer, the ratio (d/$\sigma 1$) of the thickness of the coating layer to the standard deviation of depth of concavities and convexities in the base layer, the standard deviation ($\sigma 2$) of depth of concavities and convexities in the coating layer, and the shape maintenance ratio ($\sigma 2/\sigma 1$), of the organic EL element obtained in Comparative Example 4.

[Comparative Example 5]

An organic EL element was manufactured under the same method and conditions as those of Example 5 except that no coating layer was formed. Fig. 8 schematically depicts a cross-section structure of the organic EL element obtained in Comparative Example 5. As depicted in Fig. 8, in the organic EL element 70 of Comparative Example 5, the base layer 13 having the concave-convex pattern, the first electrode 16, the organic layer 18, and the second electrode 20 were stacked on the substrate 10 in that order.

[Comparative Example 6]

An organic EL element was manufactured under the same method and conditions as those of Example 5, except that the thickness d of the coating layer was changed to 76.4 nm. The thickness d of the coating layer was 183% of the standard deviation $\sigma 1$ of depth of concavities and convexities in the base layer. The standard deviation of depth of concavities and convexities in the coating layer was 10.7 nm. The shape maintenance ratio, which was obtained by using the value of the standard deviation of depth of concavities and convexities of the coating layer and the value of the standard deviation of depth of concavities and convexities of the base layer obtained in advance, was 26%. The table of Fig. 6 shows the standard deviation ($\sigma 1$) of depth of concavities and convexities in the base layer, the thickness d of the coating layer, the ratio (d/$\sigma 1$) of the thickness of the coating layer to the standard deviation of depth of concavities and convexities in the base layer, the standard deviation ($\sigma 2$) of depth of concavities and convexities in the coating layer, and the shape maintenance ratio ($\sigma 2/\sigma 1$), of the organic EL element obtained in Comparative Example 6.

[Comparative Example 7]

An organic EL element was manufactured under the same method and conditions as those of Example 12 except that no coating layer was formed. Fig. 8 schematically depicts a cross-section structure of the organic EL element obtained in Comparative Example 7. As depicted in Fig. 8, in the organic EL element 70 of Comparative Example 7, the base layer 13 having the concave-convex pattern, the first electrode 16, the organic layer 18, and the second electrode 20 were stacked on the substrate 10 in that order.

[Comparative Example 8]

An organic EL element was manufactured under the same method and conditions as those of Example 12, except that the thickness d of the coating layer was changed to 4.8 nm. The thickness d of the coating layer was 11% of the standard deviation $\sigma 1$ of depth of concavities and convexities in the base layer. The standard deviation of depth of concavities and convexities in the coating layer was 43.1 mm. The shape maintenance ratio, which was obtained by using the value of the standard deviation of depth of concavities and convexities of the coating layer and the value of the standard deviation of depth of concavities and convexities of the base layer obtained in advance, was 99%. The table of Fig. 6 shows the standard deviation ($\sigma 1$) of depth of concavities and convexities in the base layer, the thickness d of the coating layer, the ratio (d/$\sigma 1$) of the thickness of the coating layer to the standard deviation of depth of concavities and convexities in the base layer, the standard deviation ($\sigma$2) of depth of concavities and convexities in the coating layer, and the shape maintenance ratio ($\sigma$2/$\sigma$1), of the organic EL element obtained in Comparative Example 8.

[Comparative Example 9]

An organic EL element was manufactured under the same method and conditions as those of Example 12, except that the thickness d of the coating layer was changed to 73.8 nm. The thickness d of the coating layer was 170% of the standard deviation $\sigma$1 of depth of concavities and convexities in the base layer. The standard deviation of depth of concavities and convexities in the coating layer was 18.8 nm. The shape maintenance ratio, which was obtained by using the value of the standard deviation of depth of concavities and convexities of the coating layer and the value of the standard deviation of depth of concavities and convexities of the base layer obtained in advance, was 43%. The table of Fig. 6 shows the standard deviation ($\sigma$1) of depth of concavities and convexities in the base layer, the thickness d of the coating layer, the ratio (d/$\sigma$1) of the thickness of the coating layer to the standard deviation of depth of concavities and convexities in the base layer, the standard deviation ($\sigma$2) of depth of concavities and convexities in the coating layer, and the shape maintenance ratio ($\sigma$2/$\sigma$1), of the organic EL element obtained in Comparative Example 9.

[Evaluation of leak current]

A low voltage (1.0 V) was applied to the organic EL element obtained in each of Examples 1 to 16 and Comparative Examples 1 to 9 to the extent that the element does not emit light, and a current flowing through the organic EL element was measured with a source measurement instrument (manufactured by Keithley Instruments, 2612A System SourceMeter). A current density was calculated by dividing the measured current value by a light-emitting or luminescent area of the organic EL element. The organic EL element, in which the current density at the time of applying the voltage of 1.0 V was less than $5.0 \times 10^{-7}$ A/cm$^2$, was evaluated to be satisfactory or acceptable. The organic EL element, in which the current density at the time of applying the voltage of 1.0 V was not less than $5.0 \times 10^{-7}$ A/cm$^2$, was evaluated to be unsatisfactory or defective. The table of Fig. 6 shows evaluation results of leak current, wherein "+" means that the element was satisfactory and "-" means that the element was unsatisfactory. Regarding the organic EL elements obtained in Examples 1 to 16 and Comparative Examples 1, 4, 6, and 9, current densities thereof were less than $5.0 \times 10^{-7}$ A/cm$^2$ and thus the organic EL elements were evaluated as satisfactory. Regarding the organic EL elements having no coating layer on the base layer which were obtained in Comparative Examples 2, 5, and 7 and the organic EL elements having a small thickness of the coating layer which were obtained in Comparative Examples 3 and 8, current densities thereof were not less than $5.0 \times 10^{-7}$ A/cm$^2$ and thus the organic EL elements were evaluated as unsatisfactory. Regarding the organic EL elements obtained in Examples 1 to 16 and Comparative Examples 4, 6, and 9, the following assumption can be made. Namely, even if there were any defect on the surface of the base layer, the coating layer formed on the base layer filled the defect of the surface of the base layer, thereby making it possible to prevent the occurrence of leak current which would have otherwise been caused in the first electrode layer formed on the coating layer. Regarding the organic EL element in Comparative Example 1, the following assumption can be made. Namely, the first electrode layer was formed directly on the substrate in which no base layer was formed and there was no defect which might cause the leak current. Thus, the occurrence of leak current was prevented in the organic EL element in Comparative Example 1. Regarding the organic EL elements in Comparative Examples 2, 5, and 7, the following assumption can be made. Namely, the defect of the surface of the base layer remained as it was because each of the organic EL elements had no coating layer, and thereby causing the leak current. Regarding the organic EL elements in Comparative Examples 3 and 8, the following assumption can be made. Namely, the thickness of the coating layer was too small to satisfactorily fill the defect of the surface of the base layer, and thereby causing the leak current.

[Relation between the shape maintenance ratio and the ratio of thickness of the coating layer to the standard deviation of depth of concavities and convexities of the base layer]

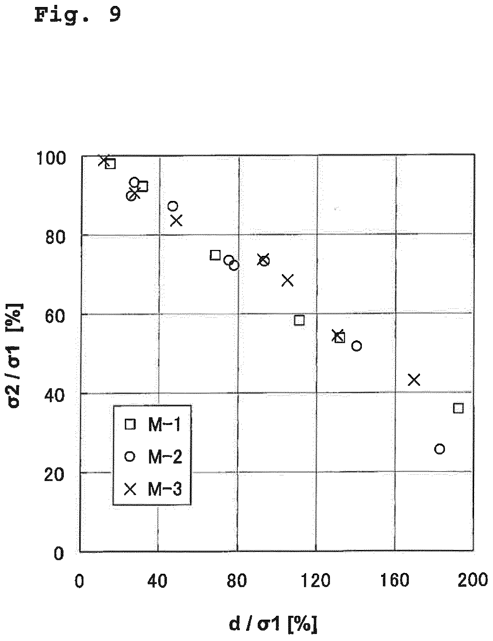

Fig. 9 is a graph in which the shape maintenance ratio ($\sigma$2/$\sigma$1) is plotted against the ratio (d/$\sigma$1) of the thickness of the coating layer to the standard deviation of depth of concavities and convexities of the base layer, for the organic EL element in each of Examples 1 to 16 and Comparative Examples 3, 4, 6, 8, and 9. Regarding Examples 1 to 4 and Comparative Examples 3 and 4 in which the film mold M-1 was used, squares were used for plotting. Regarding Examples 5 to 11 and Comparative Example 6 in which the film mold M-2 was used, circles were used for plotting. Regarding Examples 12 to 16 and Comparative Examples 8 and 9 in which the film mold M-3 was used, cross marks were used for plotting. As understood from Fig. 9, in all of the cases (regardless of the film mold types), the shape maintenance ratio ($\sigma$2/$\sigma$1) was smaller as the value of d/$\sigma$1 increased, so that the concave-convex shape in the surface of the coating layer became flat gradually.

[Evaluation of current efficiency of organic EL element]

The current efficiency of the organic EL element manufactured in each of Examples 1 to 16 and Comparative Examples 1 to 9 at a luminance of 1000 cd/m$^2$ was obtained, and the current efficiency ratio (the ratio of the current efficiency of the organic EL element manufactured in each of Examples 1 to 16 and Comparative Examples 2 to 9 with respect to the current efficiency of the organic EL element manufactured in Comparative Example 1) was calculated. The current efficiency was measured by the following method. That is, voltage was applied to each of the organic EL elements, and then the applied voltage V and a current I flowing through the organic EL element were measured with a source measurement instrument (manufactured by ADC CORPORATION, R6244), and a total luminous flux amount L was measured with a total flux measurement apparatus manufactured by Spectra Co-op. From the thus obtained measured values of the applied voltage V, the current I, and the total luminous flux amount L, a luminance value L' was calculated. Here, the following calculation formula (F1) was used to calculate the current efficiency of the organic EL element:

$$\text{Current efficiency} = (\text{L'/I}) \times \text{S} \qquad \text{(F1)}$$

In the above formula, S is a light-emitting or luminescent area of the element. Note that the value of the luminance L' was calculated on the assumption that light distribution characteristic of the organic EL element followed Lambert's law, and the following calculation formula (F2) was used:

$$\text{L'} = \text{L}/\pi/\text{S} \qquad \text{(F2)}$$

Fig. 6 shows calculation results of the current efficiency ratios. Regarding elements in Examples 1 to 4 and Comparative Examples 2 to 4 which were manufactured by using the film mold M-1, the current efficiency ratio was 1.36 in Comparative Example 2 in which no coating layer was formed, whereas the current efficiency ratio was in a range of 1.40 to 1.52 in each of Examples 1 to 4 in which the thickness of the coating layer was in a range of 31 to 132% of the standard deviation of depth of concavities and convexities of the base layer and the shape maintenance ratio ($\sigma2/\sigma1$) was in a range of 54 to 92%. Namely, the current efficiency (light emission efficiency) improved in each of Examples 1 to 4. Meanwhile, the light emission efficiency ratio was 1.36 in Comparative Example 3 in which the thickness of the coating layer was small (d/$\sigma1$= 15%) and the shape maintenance ratio ($\sigma2/\sigma1$) was large (98%). The current efficiency (light emission efficiency) of Comparative Example 3 was the same as the current efficiency (light emission efficiency) of Comparative Example 2 in which no coating layer was formed. The light emission efficiency ratio was 1.16 in Comparative Example 4 in which the thickness of the coating layer was relatively large (d/$\sigma1$= 193%) and the

shape maintenance ratio ($\sigma2/\sigma1$) was relatively small (36%). Namely, the current efficiency (light emission efficiency) of Comparative Example 4 was lower than the current efficiency (light emission efficiency) of Comparative Example 2 in which no coating layer was formed. Similarly, regarding elements of Examples 5 to 8 and Comparative Examples 5 and 6 which were manufactured by using the film mold M-2, the current efficiency ratio was 1.18 in Comparative Example 5 in which no coating layer was formed, whereas the current efficiency ratio was in a range of 1.21 to 1.40 in each of Examples 5 to 8 in which the thickness of the coating layer was in a range of 27 to 140% of the standard deviation of depth of concavities and convexities of the base layer and the shape maintenance ratio ($\sigma2/\sigma1$) was in a range of 52 to 93%. Namely, the current efficiency (light emission efficiency) improved in each of Examples 5 to 8. Meanwhile, the light emission efficiency ratio was 1.11 in Comparative Example 6 in which the thickness of the coating layer was relatively large (d/$\sigma1$= 183%) and the shape maintenance ratio ($\sigma2/\sigma1$) was relatively small (26%). Namely, the current efficiency (light emission efficiency) of Comparative Example 6 was lower than the current efficiency (light emission efficiency) of Comparative Example 5 in which no coating layer was formed. Regarding elements of Examples 9 to 11 in which the coating layers were formed by using the UV curable resin, the resin containing the silane coupling agent, and the resin containing the ultraviolet absorber respectively, the current efficiency of each of Examples 9 to 11 was greater than the current efficiency of Comparative Example 5, like the above-described Examples. Regarding elements of Examples 12 to 16 and Comparative Examples 7 to 9 which were manufactured by using the film mold M-3, the current efficiency ratio was 1.26 in Comparative Example 7 in which no coating layer was formed, whereas the current efficiency ratio was in a range of 1.27 to 1.34 in each of Examples 12 to 16 in which the thickness of the coating layer was in a range of 27 to 130% of the standard deviation of depth of concavities and convexities of the base layer and the shape maintenance ratio ($\sigma2/\sigma1$) was in a range of 54 to 91%. Namely, the current efficiency (light emission efficiency) improved in each of Examples 12 to 16. Meanwhile, the light emission efficiency ratio was 1.26 in Comparative Example 8 in which the thickness of the coating layer was small (d/$\sigma1$= 11%) and the shape maintenance ratio ($\sigma2/\sigma1$) was large (99%). Namely, the current efficiency (light emission efficiency) of Comparative Example 8 was the same as the current efficiency (light emission efficiency) of Comparative Example 7 in which no coating layer was formed. The light emission efficiency ratio was 1.17 in Comparative Example 9 in which the thickness of the coating layer was relatively large (d/$\sigma1$= 170%) and the shape maintenance ratio ($\sigma2/\sigma1$) was relatively small (43%). Namely, the current efficiency (light emission efficiency) of Comparative Example 9 was lower than the current efficiency (light emission efficiency) of Comparative Example 7 in which no coating layer was formed.

As described above, regarding the organic EL element which was manufactured by using one of the molds M-1, M-2, and M-3 in each of Examples 1 to 16 in which the coating layer was formed such that $d/\sigma1$ was in the range of 25 to 150%, i.e., the shape maintenance ratio ($\sigma2/\sigma1$) was in the range of 50 to 95%, the current efficiency was higher, irrespective of the film mold types, than the organic EL element having no coating layer obtained in each of Comparative Examples 2, 5, and 7 in which one of the film molds M-1, M-2, and M-3 was used. Here, the following assumption can be made. Namely, since the organic EL element in each of Examples 1 to 16 included the coating layer, the occurrence of leak current was prevented. Thus, the percentage of current contributing to light emission in the light emitting layer increased to improve the current efficiency. Meanwhile, regarding the organic EL element obtained in each of Comparative Examples 3 and 8 in which the coating layer was formed such that $d/\sigma1$ was less than 25%, i.e., the shape maintenance ratio ($\sigma2/\sigma1$) exceeded 95%, the current efficiency was equivalent, irrespective of the film mold types, to the organic EL element having no coating layer obtained in each of Comparative Examples 2 and 7 in which one of the film molds M-1 and M-3 was used.

Here, the following assumption can be made. Namely, regarding the organic EL element obtained in each of Comparative Example 3 and 8, the coating layer failed to prevent leak current sufficiently. Thus, unlike the organic EL element in each of Examples 1 to 16, the effect of increasing the percentage of current contributing to the light emission in the light emitting layer could not be obtained and the current efficiency did not improve. Regarding the organic EL element obtained in each of Comparative Examples 4, 6, and 9 in which the coating layer was formed such that $d/\sigma1$ exceeded 150%, i.e., the shape maintenance ratio ($\sigma2/\sigma1$) was less than 50%, the current efficiency was lower, irrespective of the film mold types, than that of the organic EL element having no coating layer obtained in each of Comparative Examples 2, 5, and 7 in which one of the film molds M-1, M-2, and M-3 was used. Here, the following assumption can be made. Namely, in the organic EL element in each of Comparative Examples 2, 5, and 7, the shape maintenance ratio was low and the surface of the coating layer was too flattened and had insufficient depth of concavities and convexities in its surface. This made it impossible to sufficiently obtain the light extraction efficiency-enhancing effect which would have otherwise been brought about by the concave-convex structure. Accordingly, the current efficiency decreased.

The evaluation results described above have revealed that the organic EL element, which was manufactured by using the diffraction grating substrate in which the coating layer was formed to have an appropriate thickness and shape maintenance ratio, had smaller leak current and higher current efficiency than those of the organic EL element manufactured by using the substrate in which no coating layer was formed on the base layer.

Although the present invention has been explained as above with the embodiment, Examples, and Comparative Examples, the method for manufacturing the substrate with the concave-convex structure and the substrate with the concave-convex structure manufactured by the method, of the present invention, are not limited to the manufacturing method and the substrate manufactured by the method in the above-described embodiment and Examples, and they may be appropriately modified or changed within the range of the technical ideas described in the following claims. The substrate with the concave-convex structure in accordance with the present invention is not limited to the production of the optical substrate, and can be used for various uses including, for example, the production of optical elements such as microlens arrays, nanoprism arrays, and optical waveguides; the production of optical components such as lenses; the production of LED; the production of solar cells; the production of antireflection films; the production of semiconductor chips; the production of patterned media; the production of data storage; the production of electronic paper; the production of LSI; paper manufacturing; food manufacturing; and the biology field such as immunoassay chips and cell culture sheets.

**Industrial** Applicability

In the method for manufacturing the substrate with the concave-convex structure according to the present invention, the coating layer is formed on the concave-convex pattern surface formed by transfer (imprint), thereby compensating or repairing a defect on the concave-convex pattern surface caused by the transfer. Thus, the manufacturing method of the present invention can manufacture the substrate having a smaller number of defects on the concave-convex surface. The substrate with concave-convex structure obtained by the manufacturing method of the present invention can effectively prevent the occurrence of leak current of a device such as the organic EL element while having good light extraction efficiency. Therefore, the method for manufacturing the substrate with the concave-convex structure and the substrate with the concave-convex structure manufactured by the method can be suitably used for various uses. Further, the organic EL element manufactured by using the substrate with such a concave-convex structure as an optical substrate is suitable for various uses such as displays and illumination devices which are required to have uniform lighting, and this organic EL element contributes to energy conservation.

Reference Signs List:

10: substrate, 12: base material layer, 13: base layer, 14: coating layer, 16: first electrode, 18: organic layer, 20: second electrode, 22: optical functional layer, 30: organic EL element, 100: substrate with concave-convex structure, 122: pressing roll, 123: peeling roll (releasing roll)

**Claims**

1. A method for manufacturing a substrate with a concave-convex structure, comprising:

forming a base material layer on a substrate;
forming a base layer having a concave-convex pattern by transferring a concave-convex pattern of a mold to the base material layer; and
forming a coating layer by coating the concave-convex pattern of the base layer with a coating material,
wherein the coating layer is formed such that a thickness of the coating layer is in a range of 25 to 150% of standard deviation of depth of concavities and convexities of the base layer.

2. The method for manufacturing the substrate with the concave-convex structure according to claim 1, wherein a maintenance ratio of standard deviation of depth of concavities and convexities of the coating layer to the standard deviation of the depth of the concavities and convexities of the base layer is in a range of 50 to 95%.

3. The method for manufacturing the substrate with the concave-convex structure according to claim 1 or 2, wherein the coating material is a sol-gel material.

4. The method for manufacturing the substrate with the concave-convex structure according to claim 1 or 2, wherein the coating material is a silane coupling agent.

5. The method for manufacturing the substrate with the concave-convex structure according to claim 1 or 2, wherein the coating material is a resin.

6. The method for manufacturing the substrate with the concave-convex structure according to claim 1 or 2, wherein the coating material contains an ultraviolet absorbent material.

7. The method for manufacturing the substrate with the concave-convex structure according to any one of claims 1 to 6, wherein the base material layer is made of a sol-gel material.

8. The method for manufacturing the substrate with the concave-convex structure according to any one of claims 1 to 6, wherein the base material layer is made of a same material as the coating material.

9. The method for manufacturing the substrate with the concave-convex structure according to any one of claims 1 to 8, wherein the thickness of the coating layer is in a range of 25 to 100% of the standard deviation of the depth of the concavities and convexities of the base layer.

10. The method for manufacturing the substrate with the concave-convex structure according to any one of claims 1 to 9, wherein a maintenance ratio of standard deviation of depth of concavities and convexities of the coating layer to the standard deviation of the depth of the concavities and convexities of the base layer is in a range of 70 to 95%.

11. The method for manufacturing the substrate with the concave-convex structure according to any one of claims 1 to 10, wherein the coating layer includes an irregular concave-convex pattern, in which orientations of concavities and convexities have no directionality, on a surface on a side opposite to the substrate.

12. The method for manufacturing the substrate with the concave-convex structure according to any one of claims 1 to 11, wherein the coating layer includes a concave-convex pattern in which an average pitch of concavities and convexities is in a range of 100 to 1500 nm and standard deviation of depth of the concavities and convexities is in a range of 10 to 100 nm.

13. A substrate with a concave-convex structure obtained by the method for manufacturing the substrate with the concave-convex structure according to any one of claims 1 to 12.

14. The substrate with the concave-convex structure according to claim 13, wherein the substrate with the concave-convex structure is a substrate used for manufacturing an organic light emitting diode.

15. An organic light emitting diode, comprising the substrate with the concave-convex structure as defined in claim 13 or 14 as a diffraction grating substrate with a concave-convex surface, wherein the organic light emitting diode is formed by successively stacking a first electrode, an organic layer, and a metal electrode on the concave-convex surface of the diffraction grating substrate.

16. The organic light emitting diode according to claim 15, further comprising an optical functional layer on a surface on a side opposite to the concave-convex surface of the diffraction grating substrate.

17. The method for manufacturing the substrate with the concave-convex structure according to claim 8, wherein the base material layer is formed by coating the substrate with a base material;
the base material and the coating material are in a form of solution containing the same material respectively; and
a concentration of the same material in the solution of the coating material is lower than a concentration of the same material in the solution of the base material.

EP 3 025 791 A1

Fig. 1

(a)

12
10

(b)

13
10

(c)

100

14
13
10

33

Fig. 2

FILM-SHAPED MOLD
TRAVELING
DIRECTION

PRESSING ROLL
ROTATING
DIRECTION

123

122

50

12

10

SUBSTRATE TRANSPORTING ⟶
DIRECTION

Fig. 3

30

20

18

16

14

13

10

Fig. 4

Fig. 5

Fig. 6

| | FILM MOLD | σ1 (nm) | σ2 (nm) | THICKNESS OF COATING LAYER d(nm) | d/σ1 (%) | SHAPE MAINTENANCE RATIO σ2/σ1 (%) | LEAK CURRENT | CURRENT EFFICIENCY RATIO |
|---|---|---|---|---|---|---|---|---|
| Ex. 1 | M-1 | 21.8 | 20.1 | 6.3 | 31 | 92 | + | 1.40 |
| Ex. 2 | M-1 | 21.8 | 16.3 | 13.8 | 69 | 75 | + | 1.52 |
| Ex. 3 | M-1 | 21.8 | 12.7 | 22.4 | 111 | 58 | + | 1.46 |
| Ex. 4 | M-1 | 21.8 | 11.7 | 26.6 | 132 | 54 | + | 1.42 |
| Ex. 5 | M-2 | 41.8 | 38.9 | 11.2 | 27 | 93 | + | 1.23 |
| Ex. 6 | M-2 | 41.8 | 36.4 | 19.5 | 47 | 87 | + | 1.36 |
| Ex. 7 | M-2 | 41.8 | 30.6 | 39.0 | 93 | 73 | + | 1.40 |
| Ex. 8 | M-2 | 41.8 | 21.6 | 58.7 | 140 | 52 | + | 1.21 |
| Ex. 9 | M-2 | 41.8 | 31.2 | 33.8 | 78 | 72 | + | 1.35 |
| Ex. 10 | M-2 | 41.8 | 37.5 | 10.7 | 26 | 90 | + | 1.21 |
| Ex. 11 | M-2 | 41.8 | 31.7 | 32.5 | 75 | 73 | + | 1.36 |
| Ex. 12 | M-3 | 43.5 | 39.4 | 11.8 | 27 | 91 | + | 1.29 |
| Ex. 13 | M-3 | 43.5 | 36.4 | 21.1 | 49 | 84 | + | 1.34 |
| Ex. 14 | M-3 | 43.5 | 32.1 | 40.1 | 92 | 74 | + | 1.32 |
| Ex. 15 | M-3 | 43.5 | 29.8 | 45.8 | 105 | 69 | + | 1.29 |
| Ex. 16 | M-3 | 43.5 | 23.7 | 56.7 | 130 | 54 | + | 1.27 |

(to be continued)

EP 3 025 791 A1

# Fig. 6(continued page)

| | FILM MOLD | σ1 (nm) | σ2 (nm) | THICKNESS OF COATING LAYER d(nm) | d/σ1 (%) | SHAPE MAINTENANCE RATIO σ2/σ1 (%) | LEAK CURRENT | CURRENT EFFICIENCY RATIO |
|---|---|---|---|---|---|---|---|---|
| Com. Ex. 1 | - | - | - | 0 | - | - | + | 1.00 |
| Com. Ex. 2 | M-1 | 21.8 | - | 0 | 0 | - | - | 1.36 |
| Com. Ex. 3 | M-1 | 21.8 | 21.4 | 3.2 | 15 | 98 | - | 1.36 |
| Com. Ex. 4 | M-1 | 21.8 | 7.8 | 38.7 | 193 | 36 | + | 1.16 |
| Com. Ex. 5 | M-2 | 41.8 | - | 0 | 0 | - | - | 1.18 |
| Com. Ex. 6 | M-2 | 41.8 | 10.7 | 76.4 | 183 | 26 | + | 1.11 |
| Com. Ex. 7 | M-3 | 43.5 | - | 0 | 0 | - | - | 1.26 |
| Com. Ex. 8 | M-3 | 43.5 | 43.1 | 4.8 | 11 | 99 | - | 1.26 |
| Com. Ex. 9 | M-3 | 43.5 | 18.8 | 73.8 | 170 | 43 | + | 1.17 |

Fig. 7

60

20
18
16
10

Fig. 8

70

20
18
16
13
10

## Fig. 9

Fig. 10

(a)

(b)

## INTERNATIONAL SEARCH REPORT

| International application No. |
| --- |
| PCT/JP2014/063802 |

| A. CLASSIFICATION OF SUBJECT MATTER |
| --- |
| *B05D5/06*(2006.01)i, *B29C59/02*(2006.01)i, *B32B3/30*(2006.01)i, *B32B9/00* (2006.01)i, *G02B5/18*(2006.01)i, *H01L51/50*(2006.01)i, *H05B33/02*(2006.01)i, *H05B33/10*(2006.01)i |
| According to International Patent Classification (IPC) or to both national classification and IPC |

| B. FIELDS SEARCHED |
| --- |
| Minimum documentation searched (classification system followed by classification symbols) |
| B05D5/06, B29C59/02, B32B3/30, B32B9/00, G02B5/18, H01L51/50, H05B33/02, H05B33/10 |

| Documentation searched other than minimum documentation to the extent that such documents are included in the fields searched |
| --- |
| Jitsuyo Shinan Koho     1922–1996  Jitsuyo Shinan Toroku Koho  1996–2014<br>Kokai Jitsuyo Shinan Koho  1971–2014  Toroku Jitsuyo Shinan Koho  1994–2014 |

| Electronic data base consulted during the international search (name of data base and, where practicable, search terms used) |
| --- |
|  |

### C. DOCUMENTS CONSIDERED TO BE RELEVANT

| Category* | Citation of document, with indication, where appropriate, of the relevant passages | Relevant to claim No. |
| --- | --- | --- |
| X | JP 2005-211707 A (Dainippon Printing Co., Ltd.),<br>11 August 2005 (11.08.2005),<br>claims; paragraphs [0001], [0025], [0033], [0041]<br>(Family: none) | 1,2,9,10,13 |
| X | JP 2007-15296 A (Nippon Paint Co., Ltd.),<br>25 January 2007 (25.01.2007),<br>claim 4; paragraphs [0044], [0061]; fig. 5<br>(Family: none) | 1,2,9,10,13 |
| X | WO 2012/077738 A1 (Asahi Kasei Corp.),<br>14 June 2012 (14.06.2012),<br>claims; paragraph [0405]<br>& US 2013/0319522 A1    & EP 2650124 A1<br>& KR 10-2013-0080857 A | 14-16 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>   25 August, 2014 (25.08.14) | Date of mailing of the international search report<br>   02 September, 2014 (02.09.14) |
| --- | --- |
| Name and mailing address of the ISA/<br>   Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/063802

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2008/010330 A1 (Nippon Sheet Glass Co., Ltd.), 24 January 2008 (24.01.2008), claims; paragraphs [0006], [0008]; fig. 2 (Family: none) | 3-8,11,12,17 |
| Y | JP 2006-76829 A (Nippon Sheet Glass Co., Ltd.), 23 March 2006 (23.03.2006), claims 1, 4, 5; paragraphs [0072], [0074] (Family: none) | 3-8,11,12,17 |
| A | JP 6-114334 A (Nippon Sheet Glass Co., Ltd.), 26 April 1994 (26.04.1994), entire text (Family: none) | 1-17 |
| A | JP 4-345675 A (Nippon Sheet Glass Co., Ltd.), 01 December 1992 (01.12.1992), entire text (Family: none) | 1-17 |
| A | JP 2010-269480 A (Toppan Printing Co., Ltd.), 02 December 2010 (02.12.2010), entire text (Family: none) | 1-17 |
| A | WO 2011/007878 A1 (JX Nippon Oil & Energy Corp.), 20 January 2011 (20.01.2011), entire text & US 2012/0132897 A1 & EP 2455786 A1 & KR 10-2012-0056822 A | 1-17 |

Form PCT/ISA/210 (continuation of second sheet) (July 2009)

## REFERENCES CITED IN THE DESCRIPTION

**Patent documents cited in the description**

- JP 2006236748 A
- WO 2011007878 A1
- WO 2012096368 A
- JP H8112879 B
- JP 5238827 A

- JP 6122852 A
- JP 6240208 A
- JP 6299118 A
- JP 6306329 A
- JP 7196986 A